# EUROPEAN PATENT APPLICATION

(11) **EP 4 704 156 A1**
(43) Date of publication of application: **04.03.2026**
(21) Application number: 24796864.7
(22) Date of filing: 16.04.2024
(51) Int. Cl.: H01L 27/146

(54) **SEMICONDUCTOR DEVICE AND ELECTRONIC EQUIPMENT**

(30) Priority: 28.04.2023 JP 2023075202
(71) Applicant: Sony Semiconductor Solutions Corporation, Atsugi-shi, Kanagawa 243-0014 (JP)
(72) Inventor: CHINO Daisuke, Atsugi-shi, Kanagawa 243-0014 (JP); FUJIWARA Susumu, Atsugi-shi, Kanagawa 243-0014 (JP)
(74) Representative: MFG Patentanwälte Meyer-Wildhagen Meggle-Freund Gerhard PartG mbB
(86) International application number: PCT/JP2024/015091
(87) International publication number: WO 2024/225110

(57) **Abstract**

There is provided a semiconductor device that makes it possible to downsize a device configuration and makes it possible to suppress occurrence of a defect such as flare caused by reflected light from a heat dissipation member.

The semiconductor device includes: a substrate; a first semiconductor element provided on the substrate; a light-transmissive member provided on the first semiconductor element on a side opposite to a side of the substrate; a second semiconductor element provided on the substrate; and a heat dissipation member provided on the second semiconductor element on the side opposite to the side of the substrate. The heat dissipation member is provided at a position lower than a top surface of the light-transmissive member.

## Description

### Technical Field

The present disclosure relates to a semiconductor device, and to an electronic apparatus.

### Background Art

As a configuration of an existing semiconductor device, there is a configuration in which a semiconductor element (a semiconductor chip) such as an LSI is mounted on a substrate, and a heat dissipation member including copper or the like is provided on the semiconductor chip (see PTL 1, for example). PTL 1 discloses a configuration in which a semiconductor chip and a stiffener that surrounds the semiconductor chip are provided on a package substrate, and a lid as a heat dissipation member is provided on the semiconductor chip and the stiffener.

In addition, as a configuration of the semiconductor device, there is a configuration in which, for example, an imaging element such as a CMOS image sensor is mounted next to the semiconductor chip on the substrate in the above-described configuration. A glass as a light-transmissive member is provided on a side of a light-receiving surface of the imaging element to protect the imaging element. In such a configuration, light from an optical system such as a lens passes through the glass to enter the light-receiving surface of the imaging element.

### Citation List

### Patent Literature

PTL 1: Japanese Unexamined Patent Application Publication No. 2007-56255

### Summary of the Invention

### Problem to be Solved by the Invention

In a configuration in which a semiconductor chip, such as an LSI, on which a heat dissipation member is attached, and an imaging element having a light-receiving surface provided with a glass are mounted adjacent to each other on a same substrate as described above, downsizing of a package of a semiconductor device leads to a state in which the heat dissipation member and the glass are disposed adjacent to each other. In other words, downsizing of the package of the semiconductor device leads to a state in which the heat dissipation member and the glass are disposed close to each other so that at least portions of side surfaces thereof are opposed to each other on the substrate.

In the configuration in which the heat dissipation member and the glass are disposed close to each other, a part of light having passed through an optical system easily enters the heat dissipation member. The light having entered the heat dissipation member is reflected by an outer surface of the heat dissipation member, and enters the glass from a side surface of the glass and passes through the glass to enter the imaging element, which may cause a defect such as flare.

The technology has been made in view of the above-described issue, and it is an object of the technology to provide a semiconductor device and an electronic apparatus that each make it possible to downsize a device configuration and to suppress occurrence of a defect such as flare caused by reflected light from a heat dissipation member.

### Means for Solving the Problem

A semiconductor device according to the present technology includes: a substrate; a first semiconductor element provided on the substrate; a light-transmissive member provided on the first semiconductor element on a side opposite to a side of the substrate; a second semiconductor element provided on the substrate; and a heat dissipation member provided on the second semiconductor element on the side opposite to the side of the substrate, in which the heat dissipation member is provided at a position lower than a top surface of the light-transmissive member.

A semiconductor device according to the present technology includes: a substrate; a first semiconductor element provided on the substrate; a light-transmissive member provided on the first semiconductor element on a side opposite to a side of the substrate; a second semiconductor element provided on the substrate; and a heat dissipation member provided on the second semiconductor element on the side opposite to the side of the substrate, in which the heat dissipation member has an opposed side surface opposed to the light-transmissive member, and the opposed side surface is formed at a position lower than a top surface of the light-transmissive member.

According to another embodiment of the semiconductor device according to the present technology, the semiconductor device includes a support frame portion that is provided on the substrate, and supports the light-transmissive member and the heat dissipation member relative to the substrate.

According to another embodiment of the semiconductor device according to the present technology, in the semiconductor device, the heat dissipation member includes a heat dissipation member main body portion that is positioned on the second semiconductor element, and a heat dissipation member extending portion that extends from the heat dissipation member main body portion to a region where the first semiconductor element is disposed in plan view.

According to another embodiment of the semiconductor device according to the present technology, in the semiconductor device, the heat dissipation member extending portion is provided to surround the first semiconductor element in plan view.

According to another embodiment of the semiconductor device according to the present technology, in the semiconductor device, the heat dissipation member includes a heat dissipation member main body portion that is positioned on the second semiconductor element, and a light-transmissive member support portion that extends from the heat dissipation member main body portion to a region where the first semiconductor element is disposed in plan view to support the light-transmissive member.

A semiconductor device according to the present technology includes: a substrate; a first semiconductor element provided on the substrate; a light-transmissive member provided on the first semiconductor element on a side opposite to a side of the substrate; a second semiconductor element provided on the substrate; a heat dissipation member provided on the second semiconductor element on the side opposite to the side of the substrate; and a light-blocking portion interposed between the light-transmissive member and the heat dissipation member.

According to another embodiment of the semiconductor device according to the present technology, the semiconductor device includes a support frame portion that is provided on the substrate, and supports the light-transmissive member and the heat dissipation member relative to the substrate, and the light-blocking portion is provided as a portion of the support frame portion.

According to another embodiment of the semiconductor device according to the present technology, in the semiconductor device, the light-blocking portion is formed by a resin filled between the light-transmissive member and the heat dissipation member.

According to another embodiment of the semiconductor device according to the present technology, in the semiconductor device, the heat dissipation member has a recessed portion that takes in a resin material that is to form the light-blocking portion.

According to another embodiment of the semiconductor device according to the present technology, in the semiconductor device, the light-blocking portion includes a covering portion that covers at least a side surface of the light-transmissive member on a side of the heat dissipation member.

According to another embodiment of the semiconductor device according to the present technology, in the semiconductor device, at least a portion of a surface of the heat dissipation member serves as a low reflection portion that is less reflective to light than another portion of the heat dissipation member.

According to another embodiment of the semiconductor device according to the present technology, the semiconductor device includes a heat dissipator having a sheet shape that is provided on a top surface of the heat dissipation member.

According to another embodiment of the semiconductor device according to the present technology, in the semiconductor device, the heat dissipation member includes a heat dissipation member main body portion that is positioned on the second semiconductor element, and a plurality of protrusion portions that each protrudes from the heat dissipation member main body portion.

According to another embodiment of the semiconductor device according to the present technology, the semiconductor device includes: a mounting substrate on which the substrate is mounted; a housing that holds a lens provided for the first imaging element; and a light-blocking member that is provided in the housing, and covers at least a portion of the heat dissipation member from the side opposite to the side of the substrate.

According to another embodiment of the semiconductor device according to the present technology, in the semiconductor device, a heat dissipation portion having a thermal conductivity higher than a thermal conductivity of a material included in the light-blocking member is provided on the light-blocking member.

An electronic apparatus according to the present technology is provided with a semiconductor device. The semiconductor device includes: a substrate; a first semiconductor element provided on the substrate; a light-transmissive member provided on the first semiconductor element on a side opposite to a side of the substrate; a second semiconductor element provided on the substrate; and a heat dissipation member provided on the second semiconductor element on the side opposite to the side of the substrate, in which the heat dissipation member is provided at a position lower than a top surface of the light-transmissive member.

An electronic apparatus according to the present technology is provided with a semiconductor device. The semiconductor device includes: a substrate; a first semiconductor element provided on the substrate; a light-transmissive member provided on the first semiconductor element on a side opposite to a side of the substrate; a second semiconductor element provided on the substrate; and a heat dissipation member provided on the second semiconductor element on the side opposite to the side of the substrate, in which the heat dissipation member has an opposed side surface opposed to the light-transmissive member, and the opposed side surface is formed at a position lower than a top surface of the light-transmissive member.

An electronic apparatus according to the present technology is provided with a semiconductor device. The semiconductor device includes: a substrate; a first semiconductor element provided on the substrate; a light-transmissive member provided on the first semiconductor element on a side opposite to a side of the substrate; a second semiconductor element provided on the substrate; a heat dissipation member provided on the second semiconductor element on the side opposite to the side of the substrate; and a light-blocking portion interposed between the light-transmissive member and the heat dissipation member.

### Brief Description of the Drawings

[FIG. 1] FIG. 1 is a side cross-sectional view of a configuration of a solid-state imaging device according to a first embodiment of the present technology.
[FIG. 2] FIG. 2 is a plan view of the configuration of the solid-state imaging device according to the first embodiment of the present technology.
[FIG. 3] FIG. 3 is a plane cross-sectional view of the solid-state imaging device according to the first embodiment of the present technology.
[FIG. 4] FIG. 4 is a diagram for describing a method of manufacturing the solid-state imaging device according to the first embodiment of the present technology.
[FIG. 5] FIG. 5 is a diagram for describing the method of manufacturing the solid-state imaging device according to the first embodiment of the present technology.
[FIG. 6] FIG. 6 is a diagram for describing the method of manufacturing the solid-state imaging device according to the first embodiment of the present technology.
[FIG. 7] FIG. 7 is a diagram for describing a configuration of a comparative example with respect to the solid-state imaging device according to the first embodiment of the present technology.
[FIG. 8] FIG. 8 is a side cross-sectional view of a configuration of a first modification example of the solid-state imaging device according to the first embodiment of the present technology.
[FIG. 9] FIG. 9 is a side cross-sectional view of a configuration of a second modification example of the solid-state imaging device according to the first embodiment of the present technology.
[FIG. 10] FIG. 10 is a side cross-sectional view of a configuration of a third modification example of the solid-state imaging device according to the first embodiment of the present technology.
[FIG. 11] FIG. 11 is a side cross-sectional view of a configuration of a fourth modification example of the solid-state imaging device according to the first embodiment of the present technology.
[FIG. 12] FIG. 12 is a side cross-sectional view of a configuration of a solid-state imaging device according to a second embodiment of the present technology.
[FIG. 13] FIG. 13 is a plane cross-sectional view of the solid-state imaging device according to the second embodiment of the present technology.
[FIG. 14] FIG. 14 is a side cross-sectional view of a configuration of a solid-state imaging device according to a third embodiment of the present technology.
[FIG. 15] FIG. 15 is a side cross-sectional view of a configuration of a modification example of the solid-state imaging device according to the third embodiment of the present technology.
[FIG. 16] FIG. 16 is a side cross-sectional view of a configuration of a solid-state imaging device according to a fourth embodiment of the present technology.
[FIG. 17] FIG. 17 is a plane cross-sectional view of the solid-state imaging device according to the fourth embodiment of the present technology.
[FIG. 18] FIG. 18 is a side cross-sectional view of a configuration of a solid-state imaging device according to a fifth embodiment of the present technology.
[FIG. 19] FIG. 19 is a partially enlarged side cross-sectional view of a configuration of a modification example of the solid-state imaging device according to the fifth embodiment of the present technology.
[FIG. 20] FIG. 20 is a side cross-sectional view of a configuration of a solid-state imaging device according to a sixth embodiment of the present technology.
[FIG. 21] FIG. 21 is a plan view of the configuration of the solid-state imaging device according to the sixth embodiment of the present technology.
[FIG. 22] FIG. 22 is a side cross-sectional view of a configuration of a modification example of the solid-state imaging device according to the sixth embodiment of the present technology.
[FIG. 23] FIG. 23 is a perspective view of a heat dissipation lid in the modification example of the solid-state imaging device according to the sixth embodiment of the present technology.
[FIG. 24] FIG. 24 is a side cross-sectional view of a configuration of a solid-state imaging device according to a seventh embodiment of the present technology.
[FIG. 25] FIG. 25 is a diagram for describing a process of manufacturing the solid-state imaging device according to the seventh embodiment of the present technology.
[FIG. 26] FIG. 26 is a side cross-sectional view of a configuration of a modification example of the solid-state imaging device according to the seventh embodiment of the present technology.
[FIG. 27] FIG. 27 is a diagram for describing a method of manufacturing the solid-state imaging device according to the seventh embodiment of the present technology.
[FIG. 28] FIG. 28 is a side cross-sectional view of a configuration of a solid-state imaging device according to an eighth embodiment of the present technology.
[FIG. 29] FIG. 29 is a diagram for describing a method of manufacturing the solid-state imaging device according to the eighth embodiment of the present technology.
[FIG. 30] FIG. 30 is a side cross-sectional view of a configuration of a modification example of the solid-state imaging device according to the eighth embodiment of the present technology.
[FIG. 31] FIG. 31 is a diagram for describing a method of manufacturing the modification example of the solid-state imaging device according to the eighth embodiment of the present technology.
[FIG. 32] FIG. 32 is a side cross-sectional view of a configuration of a solid-state imaging device according to a ninth embodiment of the present technology.
[FIG. 33] FIG. 33 is a plane cross-sectional view of the configuration of the solid-state imaging device according to the ninth embodiment of the present technology.
[FIG. 34] FIG. 43 is a side cross-sectional view of a configuration of a modification example of the solid-state imaging device according to the ninth embodiment of the present technology.
[FIG. 35] FIG. 35 is a block diagram illustrating a configuration example of an electronic apparatus including a solid-state imaging device according to an embodiment of the present technology.

### Modes for Carrying Out the Invention

In a configuration in which a first semiconductor element above which a light-transmitting member is disposed and a second semiconductor element on which a heat dissipation member is attached are mounted adjacent to each other on a same substrate, the present technology aims to suppress occurrence of a defect such as flare caused by reflected light from the heat dissipation member while allowing for downsizing of a device by contriving a configuration related to the heat dissipation member, and the like.

Embodiments for implementing the present technology (hereinafter referred to as "embodiments") will be described below with reference to the drawings. It is to be noted that the drawings are schematic, and ratios and the like of dimensions of respective components do not necessarily match with actual ones. Moreover, it is a matter of course that portions that have different dimensional relations and ratios among drawings are also included. In the embodiments to be described below, a solid-state imaging device including a solid-state imaging element as an example of a semiconductor element will be described as an example of a semiconductor device. The embodiments will be described in the following order.
1. Configuration Example of Solid-state Imaging Device According to First Embodiment
2. Method of Manufacturing Solid-state Imaging Device According to First Embodiment
3. Modification Examples of Solid-state Imaging Device According to First Embodiment
4. Configuration Example of Solid-state Imaging Device According to Second Embodiment
5. Configuration Example of Solid-state Imaging Device According to Third Embodiment
6. Modification Example of Solid-state Imaging Device According to Third Embodiment
7. Configuration Example of Solid-state Imaging Device According to Fourth Embodiment
8. Configuration Example of Solid-state Imaging Device According to Fifth Embodiment
9. Modification Examples of Solid-state Imaging Device According to Fifth Embodiment
10. Configuration Example of Solid-state Imaging Device According to Sixth Embodiment
11. Modification Example of Solid-state Imaging Device According to Sixth Embodiment
12. Configuration Example of Solid-state Imaging Device According to Seventh Embodiment
13. Modification Example of Solid-state Imaging Device According to Seventh Embodiment
14. Method of Manufacturing Solid-state Imaging Device According to Seventh Embodiment
15. Configuration Example of Solid-state Imaging Device According to Eighth Embodiment
16. Method of Manufacturing Solid-state Imaging Device According to Eighth Embodiment
17. Modification Example of Solid-state Imaging Device According to Eighth Embodiment
18. Method of Manufacturing Modification Example of Solid-state Imaging Device According to Eighth Embodiment
19. Configuration Example of Imaging Device According to Ninth Embodiment
20. Modification Example of Imaging Device According to Ninth Embodiment
21. Configuration Example of Electronic Apparatus

### <1. Configuration Example of Solid-state Imaging Device According to First Embodiment>

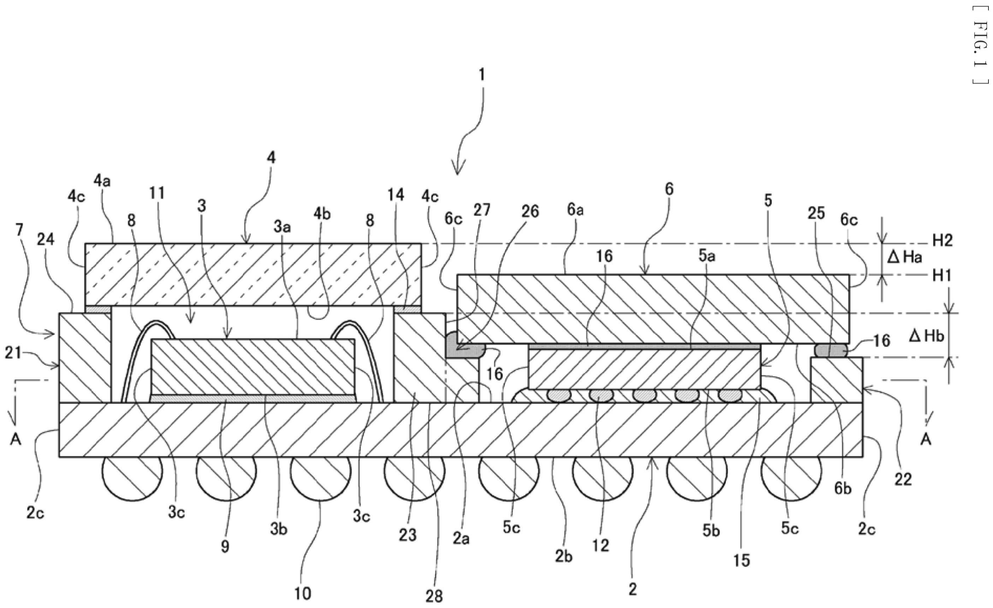

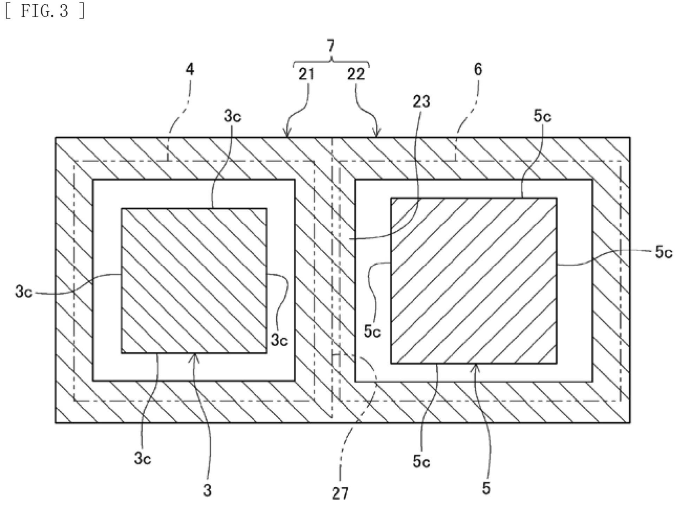

Description is given, with reference to FIGs. 1 to 3, of a configuration example of a solid-state imaging device according to a first embodiment of the present technology. It is to be noted that a top and a bottom in FIG. 1 will be described respectively as a top and a bottom of a solid-state imaging device 1. In addition, FIG. 3 is a plane cross-sectional view at a position A-A of FIG. 1.

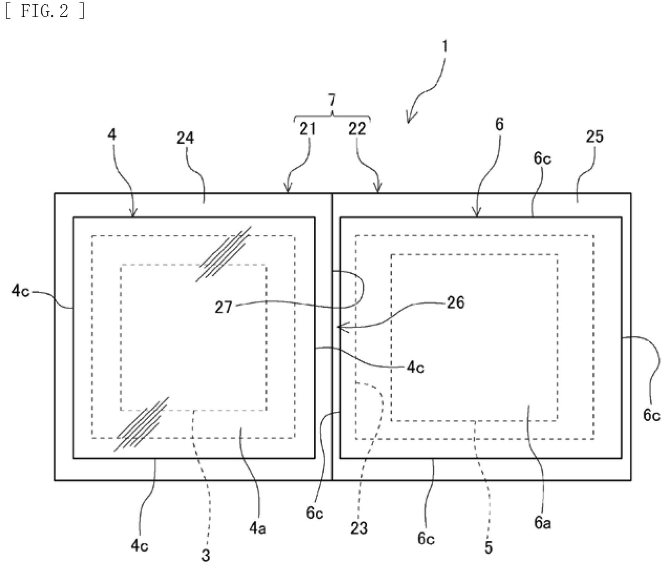

As illustrated in FIGs. 1 and 2, the solid-state imaging device 1 includes a substrate 2, an image sensor 3 that is a solid-state imaging element as a first semiconductor element provided on the substrate 2, a glass 4 as a light-transmissive member, an LSI (Large Scale Integration) 5 as a second semiconductor element provided on the substrate 2, a heat dissipation lid 6 as a heat dissipation member, and a stiffener 7 as a support frame portion. The solid-state imaging device 1 has a multi-chip package structure in which the image sensor 3 and the LSI 5 are disposed on a same plane in a same package.

The substrate 2 is an interposer substrate, and is a flat plate-shaped member having a rectangular plate-shaped outer shape. The substrate 2 has a front surface 2a that is one plate surface on which the image sensor 3 and the LSI 5 are mounted, a back surface 2b that is another plate surface on a side opposite to the front surface 2a, and four side surfaces 2c. A plate thickness direction of the substrate 2 will be described as an up-down direction in the solid-state imaging device 1. A side of the front surface 2a will be described as an upper side, and a side of the back surface 2b will be described as a lower side.

The substrate 2 has, as an outer shape in plan view, for example, a rectangular shape having a dimension in a long-side direction that is about twice as long as a dimension in a short-side direction. Hereinafter, the long-side direction of the substrate 2 in plan view (a right-left direction in FIG. 2) is referred to as a "substrate long-side direction", and the short-side direction of the substrate 2 in plan view (an up-down direction in FIG. 2) is referred to as a "substrate short-side direction".

The substrate 2 is an organic substrate including, as a base material, for example, an organic material such as a glass epoxy resin that is one kind of fiber reinforced plastic, and is a circuit substrate on which a wiring layer, an electrode, or a predetermined pattern is formed using a metal material. However, the substrate 2 may be a ceramic substrate including, as a base material, for example, ceramic such as alumina (Al₂O₃), aluminum nitride (AlN), or silicon nitride (Si₃N₄), or a substrate of any other kind such as a glass substrate using a glass.

A plurality of electrode pads (not illustrated) each of which is an electrode portion to be electrically coupled to the image sensor 3 is formed around a region where the image sensor 3 is mounted on the front surface 2a of the substrate 2. The plurality of electrode pads is formed in a predetermined arrangement in relation to an arrangement of a plurality of electrode sections formed on a front surface of the image sensor 3.

The image sensor 3 is a semiconductor element including a semiconductor substrate including silicon (Si) that is an example of a semiconductor. The image sensor 3 is a semiconductor chip having a rectangular plate shape, and has a front surface 3a that is one plate surface, and a back surface 3b that is another plate surface on a side opposite to the front surface 3a. A side of the front surface 3a will be described as a side of a light-receiving surface.

A plurality of light-receiving elements (photoelectric conversion elements) is formed on the side of the front surface 3a of the image sensor 3. The image sensor 3 is a CMOS (Complementary Metal Oxide Semiconductor) image sensor. However, the image sensor 3 may be another imaging element such as a CCD (Charge Coupled Device) image sensor.

The image sensor 3 includes, on the side of the front surface 3a, a pixel region that is a light-receiving region where many pixels are formed, and a peripheral region that is a region around the pixel region. In the pixel region, many pixels are formed in a predetermined arrangement such as a Bayer arrangement, for example, and each configure a light-receiving section in the image sensor 3. The pixels in the pixel region each include a photodiode as a photoelectric conversion section having photoelectric conversion function, and a plurality of pixel transistors. In the peripheral region, a predetermined peripheral circuit is formed.

On the side of the front surface 3a of the image sensor 3, a color filter and an on-chip lens are formed corresponding to each pixel on the semiconductor substrate with an antireflective film including an oxide film or the like, a planarization film including an organic material, or the like interposed therebetween. Light having entered the on-chip lens is received by the photodiode through the color filter, the planarization film, and the like.

In the peripheral region of the front surface 3a of the image sensor 3, a plurality of electrode pads (not illustrated) each of which is an electrode portion to be electrically coupled to the substrate 2 is formed in a predetermined arrangement. For example, the plurality of electrode pads is provided side by side along four side portions of the image sensor 3 in an outer edge portion of the front surface 3a of the image sensor 3, or is provided side by side along a pair of side portions opposed to each other of the image sensor 3.

The image sensor 3 is disposed in a middle portion in a substantially half region on one side in the substrate long-side direction (on a left side in FG. 2) in the front surface 2a of the substrate 2 to align an outer shape thereof in plan view with the substrate 2. The image sensor 3 is adhered to the front surface 2a of the substrate 2 by a die bonding material 9 including an insulating or electrically conductive adhesive.

It is to be noted that a configuration of the image sensor 3 according to the present technology is not particularly limited. Examples of the configuration of the image sensor 3 include a front-illuminated (Front Side Illumination) configuration in which the pixel region is formed on a side of a front surface of a semiconductor substrate, and a back-illuminated (Back Side Illumination) configuration in which a photodiode or the like is disposed on an opposite side to improve a light transmittance and a side of a back surface of a semiconductor substrate is the side of the light-receiving surface.

The image sensor 3 is electrically coupled to the substrate 2 by wires (bonding wires) 8 as a plurality of coupling members. The wires 8 are electrically conductive wires that electrically couple the substrate 2 and the image sensor 3 to each other. The wires 8 are, for example, thin metallic wires including Au (gold), Cu (copper), Al (aluminum), or the like.

The wires 8 each have one end coupled to the electrode pad of the substrate 2, and another end coupled to the electrode pad of the image sensor 3, and electrically couple these electrode pads to each other. For example, aluminum, copper, or the like is used as materials of the electrode pads of the substrate 2 and the image sensor 3.

The plurality of electrode pads of the substrate 2 is electrically coupled to a plurality of terminal electrodes formed on the side of the back surface 2b of the substrate 2 through a predetermined wiring portion formed in the substrate 2. A solder ball 10 is provided as a coupling terminal for each terminal electrode. The solder balls 10 are two-dimensionally formed, for example, along the rectangular outer shape of the substrate 2 in a lattice point arrangement to configure a BGA (Ball Grid Array). The solid-state imaging device 1 is reflow-mounted on a set substrate that is a circuit substrate including a predetermined circuit by a group of the solder balls 10.

The glass 4 is provided on the image sensor 3 on the upper side opposite to a side of the substrate 2. The glass 4 is a transparent cover member that covers the image sensor 3 from above. The glass 4 is provided in a state of being fixed to the substrate 2 through the stiffener 7, and is positioned above the image sensor 3. That is, the glass 4 is provided above the image sensor 3 in a state of being supported by the stiffener 7 provided on the substrate 2.

The glass 4 has a rectangular plate-shaped outer shape, and has a top surface 4a that is an upper plate surface, a bottom surface 4b that is a plate surface on a side opposite to the top surface 4a and is opposed to the image sensor 3, and four side surfaces 4c. The glass 4 is provided in parallel to the image sensor 3 at a predetermined interval. The glass 4 is, for example, a borosilicate glass.

The glass 4 is a flat plate-shaped member having an outside dimension larger than that of the image sensor 3, and is provided so as to cause the entire image sensor 3 to be positioned within a range of the outer shape in plan view. The glass 4 has an outside dimension that substantially entirely covers the substantially half region on the one side in the substrate long-side direction, and the entire glass 4 is provided to be positioned within a range of the outer shape of the substrate 2 in plan view.

The glass 4 is adhered and fixed to the stiffener 7 by an adhesive 14. Examples of the adhesive 14 include an adhesive such as an epoxy resin-based adhesive or an acrylic resin-based adhesive.

The glass 4 allows various kinds of light having entered from a side of the top surface 4a through an optical system such as a lens positioned above the glass to pass therethrough. The light having passed through the glass 4 reaches the light-receiving surface of the image sensor 3 through a cavity 11 that is a space portion around the image sensor 3. The glass 4 has a function of protecting the side of the light-receiving surface of the image sensor 3. It is to be noted that, as a transparent member or a light-transmissive member according to the present technology, it is possible to use, for example, a plastic plate, a silicon plate, or the like in place of the glass 4.

The LSI 5 is a semiconductor element including silicon (Si) or the like that is an example of a semiconductor. The LSI 5 is a semiconductor chip having a predetermined circuit structure, and is an example of a logic chip. The LSI 5 has a rectangular plate-shaped outer shape, and has a front surface that is one plate surface on which a plurality of electrodes or the like is formed, and a back surface that is a surface on a side opposite to the front surface. The front surface is referred to as a bottom surface 5b, and the back surface is referred to as a top surface 5a. The LSI 5 has four side surfaces 5c.

The LSI 5 is disposed on the same front surface 2a of the substrate 2 where the image sensor 3 is disposed. The LSI 5 is disposed in a middle portion in a substantially half region on another side in the substrate long-side direction (on a right side in FG. 2) in the front surface 2a of the substrate 2 to align an outer shape thereof in plan view with the substrate 2.

The LSI 5 is mounted on the substrate 2 by what is called flip-chip bonding. The LSI 5 is electrically coupled to the substrate 2 through a coupling terminal 12 such as a metal bump that is a protruding terminal provided for each electrode formed on a side of the bottom surface 5b. Each coupling terminal 12 is coupled to an electrode formed on the side of the front surface 2a of the substrate 2. The coupling terminal 12 is, for example, a stud bump such as Cu or Au, a solder ball bump, or the like.

An underfill portion 15 that covers a plurality of coupling terminals 12 for protection, reinforcement, and the like of the coupling terminals 12 and a coupling portion by the coupling terminals 12 is provided between the substrate 2 and the LSI 5. The underfill portion 15 is a resin sealing portion with which a gap between the substrate 2 and the LSI 5 is sealed. Examples of a material of the underfill portion 15 include a thermosetting resin such as an epoxy-based resin and a thermosetting resin in which a filler including silicon oxide as a main component is dispersed.

Hereinafter, the substrate long-side direction (the right-left direction in FIG. 1) will be described as a "right-left direction", a side where the image sensor 3 is disposed in the substrate long-side direction will be described as a "left side", and a side where the LSI 5 is disposed will be described as a "right side".

The heat dissipation lid 6 is provided on the LSI 5 on the upper side that is a side opposite to the side of the substrate 2. The heat dissipation lid 6 is provided in a state of being supported by and fixed to each of the LSI 5 and the stiffener 7 that are provided on the substrate 2. The heat dissipation lid 6 has a rectangular plate-shaped outer shape, and has a top surface 6a that is an upper plate surface, a bottom surface 6b that is a plate surface on a side opposite to the top surface 6a, and four side surfaces 6c. The heat dissipation lid 6 has a plate thickness substantially equal to a plate thickness of the glass 4 or thicker than the plate thickness of the glass 4.

The heat dissipation lid 6 is a flat plate-shaped member having an outside dimension larger than an outside dimension of the LSI 5, and is provided so as to cause the entire LSI 5 to be positioned within a range of the outer shape in plan view. The heat dissipation lid 6 has an outside dimension that substantially entirely covers the substantially half region on the other side in the substrate long-side direction of the substrate 2, and the entire heat dissipation lid 6 is provided to be positioned within the range of the outer shape of the substrate 2 in plan view.

The heat dissipation lid 6 is adhered and fixed to each of the LSI 5 and the stiffener 7 by an adhesive 16. Examples of the adhesive 16 include a die bonding material that is a resin-based adhesive having a relatively high thermal conductivity, and a thermally conductive adhesive such as a TIM (Thermal Interface Material) to which a filler for increasing a thermal conductivity is added.

The heat dissipation lid 6 is entirely adhered to the LSI 5, and receives heat generated in and transferred from the LSI 5, and dissipates the heat. In addition, the heat dissipation lid 6 receives heat transferred from the substrate 2 through the stiffener 7, the LSI 5, and the like, and dissipates the heat.

The material of the heat dissipation lid 6 is not particularly limited. However, as the material of the heat dissipation lid 6, a material having a high thermal conductivity is preferable in terms of a heat dissipation property, and a material having a low coefficient of linear expansion is preferable in terms of suppression of deformation caused by heat. Examples of the material of the heat dissipation lid 6 include copper (Cu), a copper alloy, tungsten (W), aluminum (Al), stainless steel (SUS), a Fe-Ni-Co alloy, a 42 alloy, and the like. It is to be noted that the heat dissipation lid 6 may be, for example, a member including, for example, a material, such as ceramic or a resin, other than metal materials.

The stiffener 7 is a portion that is provided on the substrate 2, and supports the glass 4 and the heat dissipation lid 6 relative the substrate 2. The stiffener 7 is provided to form a rectangular frame-shaped portion for each semiconductor chip so as to surround each of the image sensor 3 and the LSI 5 on the substrate 2. The stiffener 7 has a function as a reinforcing portion that suppresses warpage of the substrate 2, and is provided along an outer edge portion on the substrate 2.

The stiffener 7 includes a first support frame portion 21 that surrounds the image sensor 3 on every side, and a second support frame portion 22 that surrounds the LSI 5 on every side, and is provided as an integral portion in which these support frame portions are continuous with each other. The first support frame portion 21 and the second support frame portion 22 each form a rectangular frame-shaped surrounding wall portion in plan view along the outer shape of the image sensor 3 or the LSI 5, and are each provided to be aligned with the outer shape of the substrate 2 in plan view. The first support frame portion 21 and the second support frame portion 22 each form a rectangular opening portion in plan view on the substrate 2.

The stiffener 7 includes, in each of the first support frame portion 21 and the second support frame portion 22, four linear side portions that form a rectangular frame shape along the outer shape of the substrate 2 in plan view. Side portions, which are adjacent (opposed) to each other, of the first support frame portion 21 and the second support frame portion 22 are coupled together to form an integral intermediate side portion 23.

Each of side portions of the first support frame portion 21 and the second support frame portion 22 has a rectangular outer shape in cross-sectional view (see FIG. 1). In addition, each of the same side portions has an inner side surface that is a surface on an inner side (on a side of the semiconductor chip) in a frame shape of each of the first support frame portion 21 and the second support frame portion 22, and an outer surface that is a surface on a side opposite to the inner surface (on an outer side).

The first support frame portion 21 and the second support frame portion 22 are provided so as to cause the outer surface of each side portion to be continuous with the side surface 2c of the substrate 2 on a same plane. Note that the first support frame portion 21 and the second support frame portion 22 may be provided so as to cause the outer surface of each side portion to be positioned inside or outside the side surface 2c of the substrate 2.

In the stiffener 7, a top surface of the first support frame portion 21 serves as a glass support surface 24 that is a first support surface on which the glass 4 is attached. The glass support surface 24 is a surface formed by top surfaces of four side portions of the first support frame portion 21, and has a rectangular frame shape in plan view. The glass support surface 24 is formed as a flat surface positioned on a predetermined virtual plane perpendicular to the up-down direction.

The glass support surface 24 is contacted with an outer edge portion of the bottom surface 4b of the glass 4 through the adhesive 14 to support the glass 4. The glass 4 is fixed to the glass support surface 24 by the adhesive 14 so as to cause the entire rectangular opening portion on the upper side of the first support frame portion 21 to be closed by the glass 4, thus causing the image sensor 3 on the substrate 2 to be in a state of being sealed with the glass 4 and the first support frame portion 21 of the stiffener 7. The glass support surface 24 causes the entire glass 4 to be positioned within the range of the outer shape in plan view, and the four side surfaces 4c of the glass 4 are each positioned on the glass support surface 24.

In the stiffener 7, a top surface of the second support frame portion 22 serves as a lid support surface 25 that is a second support surface on which the heat dissipation lid 6 is attached. The lid support surface 25 is a surface formed by the top surfaces of four side portions of the second support frame portion 22, and has a rectangular frame shape in plan view. The lid support surface 25 is formed as a flat surface positioned on a predetermined virtual plane perpendicular to the up-down direction.

The lid support surface 25 is contacted with an outer edge portion of the bottom surface 6b of the heat dissipation lid 6 through the adhesive 16 to support the heat dissipation lid 6 together with the LSI 5. The heat dissipation lid 6 is fixed to the lid support surface 25 and the top surface 5a of the LSI 5 by the adhesive 16 so as to cause the entire rectangular opening portion on the upper side of the second support frame portion 22 to be closed by the heat dissipation lid 6, thus causing the LSI 5 on the substrate 2 to be in a state of being sealed with the heat dissipation lid 6 and the second support frame portion 22 of the stiffener 7. The lid support surface 25 causes the entire heat dissipation lid 6 to be positioned within the range of the outer shape in plan view, and the four side surface 6c of the heat dissipation lid 6 are each positioned on the lid support surface 25.

The lid support surface 25 is formed at a low position to form a step portion 26 with respect to the glass support surface 24. The step portion 26 is formed in the intermediate side portion 23, and has a step surface 27 that couples, to each other, the glass support surface 24 and the lid support surface 25 adjacent to each other in the intermediate side portion 23. The step surface 27 is formed as a surface along the up-down direction to form a right angle with each of the glass support surface 24 and the lid support surface 25 in side cross-sectional view as illustrated in FIG. 1. The lid support surface 25 is formed, for example, at a height position of a substantially middle of the first support frame portion 21 in the up-down direction.

In addition, the stiffener 7 has a bottom surface 28 that is a surface bonded to the substrate 2. It is to be noted that the step portion 26 is formed only in the intermediate side portion 23; however, for example, in the second support frame portion 22, a rectangular recessed portion into which the heat dissipation lid 6 is to be fitted may be formed by forming a step along the four sides of the heat dissipation lid 6.

The stiffener 7 is a portion formed in a predetermined shape on the substrate 2 by injection molding, transfer molding, or the like using a molding die such as a transfer molding die. Examples of a material of the stiffener 7 include a material including silicon oxide as a main component and a thermosetting resin including a filler such as alumina. Specifically, as a resin material that forms the stiffener 7, for example, any of a thermosetting resin such as a phenol-based resin, a silicone-based resin, an acrylic-based resin, an epoxy-based resin, or a urethane-based resin, a thermoplastic resin such as polyamide imide or polypropylene, a photosensitive resin such as a UV curable resin that is an acrylic-based resin, a rubber, and another known resin material is used alone, or two or more of them are used in combination.

In addition, as the material of the stiffener 7, for example, a low-reflective black resin material in which a black pigment such as carbon black or titanium black is included in a resin such as a liquid crystal polymer or a PEEK (polyether ether ketone), or a material having a light-blocking property is used in terms of preventing light reflection. As a result, the stiffener 7 is a black portion, which allows the stiffener 7 to function as a light-blocking portion.

In addition, the stiffener 7 may be a portion provided by fixing a frame member having a predetermined shape including, for example, a resin material such as an epoxy resin, a metal material such as stainless steel or copper (Cu), ceramic, or the like to the substrate 2 by an adhesive or the like. In addition, the stiffener 7 is not limited to a portion entirely including one kind of material, and may have a composite structure including, for example, a portion including a metal material and a portion including a resin material.

In the solid-state imaging device 1 having a configuration as described above, the heat dissipation lid 6 is provided at a position lower than the top surface 4a of the glass 4. As illustrated in FIG. 1, the heat dissipation lid 6 is provided so as to cause a height position H1 of the top surface 6a thereof to be lower than a height position H2 of the top surface 4a of the glass 4. As one example, a dimension of a difference ΔHa in height between the height position H1 and the height position H2 is a value within a range from 100 µm to 300 µm.

In the present embodiment, as a configuration for making the top surface 6a of the heat dissipation lid 6 lower than the top surface 4a of the glass 4, a height difference ΔHb is provided between the glass support surface 24 and the lid support surface 25 in the stiffener 7. According to such a configuration, in a case where the plate thicknesses of the glass 4 and the heat dissipation lid 6 are the same as each other, a height position of the top surface 6a of the heat dissipation lid 6 is lower than a height position of the top surface 4a of the glass 4 by the height difference ΔHb between the support surfaces caused by making the height position of the lid support surface 25 lower than the height position of the glass support surface 24.

In addition, in a case where the plate thickness of the heat dissipation lid 6 is larger than the plate thickness of the glass 4, the stiffener 7 is formed so as to cause a dimension of the height difference ΔHb between the glass support surface 24 and the lid support surface 25 to be larger than a dimension of the difference ΔHa in accordance with the dimension of the difference ΔHa. That is, a difference between the plate thicknesses of the heat dissipation lid 6 and the glass 4, that is, the dimension of the height difference ΔHb between the support surfaces in the stiffener 7 is set larger than the dimension of the difference ΔHa to ensure the dimension of the difference ΔHa.

The dimension of the difference ΔHa in height between the height position H1 and the height position H2 is set to be larger than a half of the plate thickness of the glass 4, for example. That is, in this case, the dimension of the difference ΔHa is set so as to cause the height position H1 of the top surface 6a of the heat dissipation lid 6 to be lower than a height position of a middle of the glass 4 in the plate thickness direction (in the up-down direction).

### <2. Method of Manufacturing Solid-state Imaging Device According to First Embodiment>

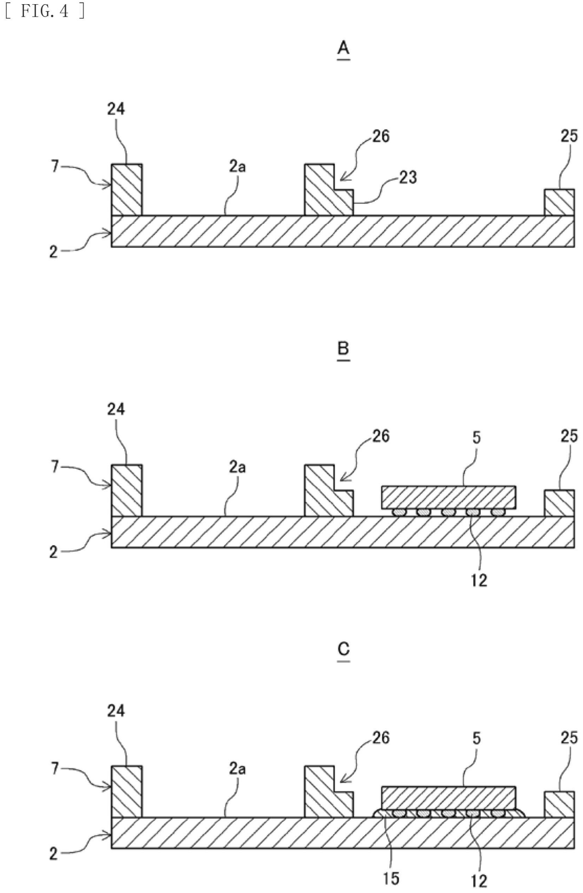

Description is given, with reference to FIGs. 4 to 6, of an example of a method of manufacturing the solid-state imaging device 1 according to the first embodiment of the present technology.

As illustrated in FIG. 4A, in the method of manufacturing the solid-state imaging device 1, first, a process of providing the stiffener 7 on the substrate 2 is performed. The stiffener 7 is a frame body that surrounds a chip mounting area on the front surface 2a of the substrate 2 and on which the glass 4 and the heat dissipation lid 6 are mounted, and is provided as a reinforcing material of the substrate 2. The stiffener 7 is provided as a resin portion including a resin material by injection molding using a molding die, for example. It is to be noted that the stiffener 7 may be a portion provided by fixing a frame member having a predetermined shape to the front surface 2a of the substrate 2 by an adhesive or the like.

Next, as illustrated in FIG. 4B, a process of providing the LSI 5 on the substrate 2 is performed. The LSI 5 is mounted on the substrate 2 by flip-chip bonding. The flip-chip bonding is performed using an ultrasonic bonding method, a pressure welding method, a method using an electrically conductive adhesive, a method using a film-shaped anisotropic electrically conductive film, or the like, as appropriate, depending on the type of metal of the coupling terminal 12. The coupling terminals 12 are formed on a side of the LSI 5 or on the side of the substrate 2 upon mounting of the LSI 5.

Next, as illustrated in FIG. 4C, a process of forming the underfill portion 15 between the substrate 2 and the LSI 5 is performed. In this process, a paste or liquid resin material is fed into a gap between the substrate 2 and the LSI 5 by, for example, a dispenser. The resin material flows by a capillary phenomenon and diffuses to cover the entirety of the plurality of coupling terminals 12 and fill the gap between the substrate 2 and the LSI 5 therewith. Thereafter, baking is performed under a predetermined temperature condition to thereby cure the resin material. Thus, the underfill portion 15 is formed. By the underfill portion 15, a short circuit and migration upon remelting of the coupling terminals 12 is prevented, and coupling reliability is improved.

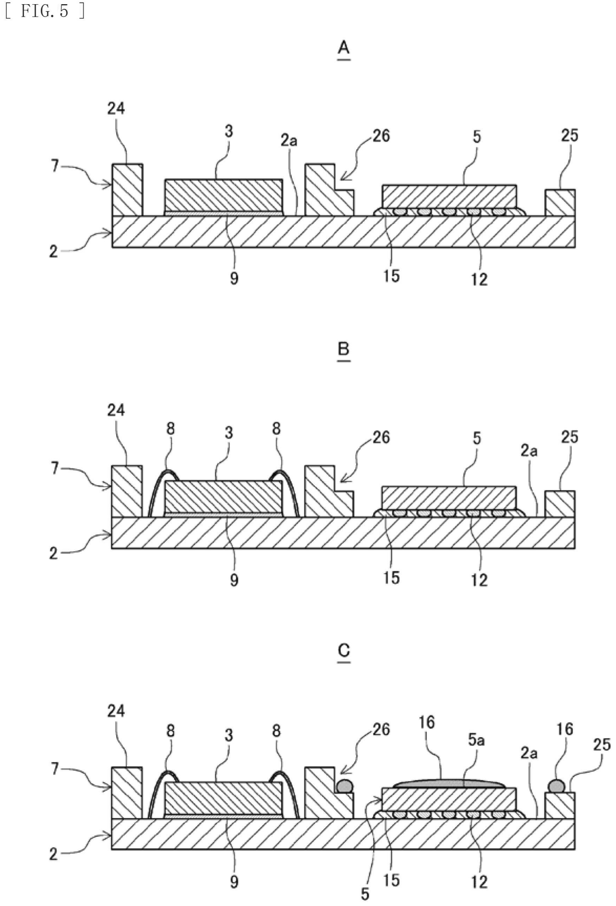

Next, as illustrated in FIG. 5A, a die bonding process is performed to provide the image sensor 3 on the substrate 2. In this process, a predetermined portion of the front surface 2a of the substrate 2 is coated with an adhesive as the die bonding material 9, and the image sensor 3 is adhered and fixed onto the front surface 2a of the substrate 2.

Subsequently, as illustrated in FIG. 5B, a process of electrically coupling the substrate 2 and the image sensor 3 to each other is performed. In this process, a wire bonding process is performed to provide the wires 8 that each electrically couple the substrate 2 and the image sensor 3 to each other. That is, in this process, the electrode pads on the substrate 2 and the electrode pads on the image sensor 3 are coupled by the wires 8, thus electrically coupling the substrate 2 and the image sensor 3 to each other.

Next, a process of providing the heat dissipation lid 6 on the LSI 5 and the stiffener 7 is performed. Specifically, as illustrated in FIG. 5C, first, the top surface 5a of the LSI 5 and the lid support surface 25 of the stiffener 7 are coated with the adhesive 16 such as a TIM material.

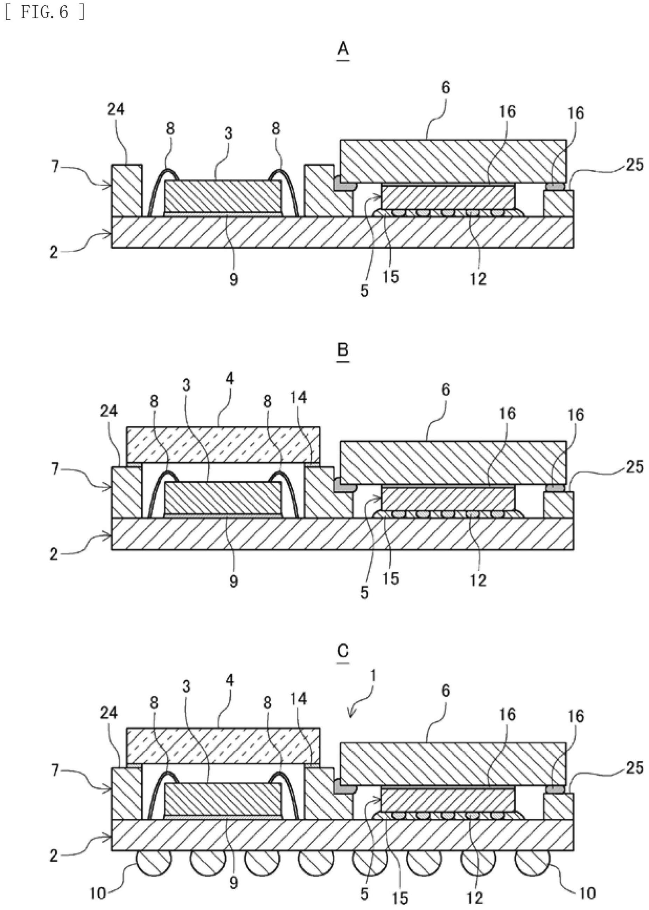

Thereafter, as illustrated in FIG. 6A, the heat dissipation lid 6 is mounted on the top surface 5a of the LSI 5 and the lid support surface 25 of the stiffener 7. The heat dissipation lid 6 is mounted to close the opening portion of the second support frame portion 22 having the lid support surface 25 as an opening end surface. Thereafter, a process of curing the adhesive 16 is performed so as to cause the heat dissipation lid 6 to be in a state of being adhered and fixed to the top surface 5a of the LSI 5 and the lid support surface 25 of the stiffener 7 by the adhesive 16.

Next, as illustrated in FIG. 6B, a process of providing the glass 4 on the stiffener 7 is performed. In this process, first, the glass support surface 24 is coated with the adhesive 14. Thereafter, the glass 4 is mounted on the glass support surface 24 of the stiffener 7. The glass 4 is mounted to close the opening portion of the first support frame portion 21 having the glass support surface 24 as an opening end surface. Thereafter, a process of curing the adhesive 14 is performed to thereby adhere and fix the glass 4 to the glass support surface 24 by the adhesive 14.

Thereafter, as illustrated in FIG. 6C, a process of providing a plurality of solder balls 10 on the side of the back surface 2b of the substrate 2 is performed. Here, processes of ball mounting and reflow are performed to dispose and fix solder to each of the plurality of terminal electrodes formed on the side of the back surface 2b of the substrate 2.

The solid-state imaging device 1 is obtained through the above-described manufacturing processes. It is to be noted that the order of the processes to be performed in the method of manufacturing the solid-state imaging device 1 is not limited to the above-described example. For example, the process of providing the LSI 5 on the substrate 2 may be performed after the process of providing the image sensor 3 on the substrate 2, or the process of mounting the heat dissipation lid 6 may be performed after the process of mounting the glass 4.

According to the solid-state imaging device 1 according to the present embodiment as described above, it is possible to downsize a device configuration, and it is possible to suppress occurrence of a defect such as flare caused by reflected light from the heat dissipation lid 6.

In the solid-state imaging device 1, the heat dissipation lid 6 is provided at a position lower than the top surface 4a of the glass 4. According to such a configuration, it is possible to suppress entry of the reflected light from the heat dissipation lid 6 into the image sensor 3 through the glass 4, thus making it possible to suppress occurrence of a defect such as flare.

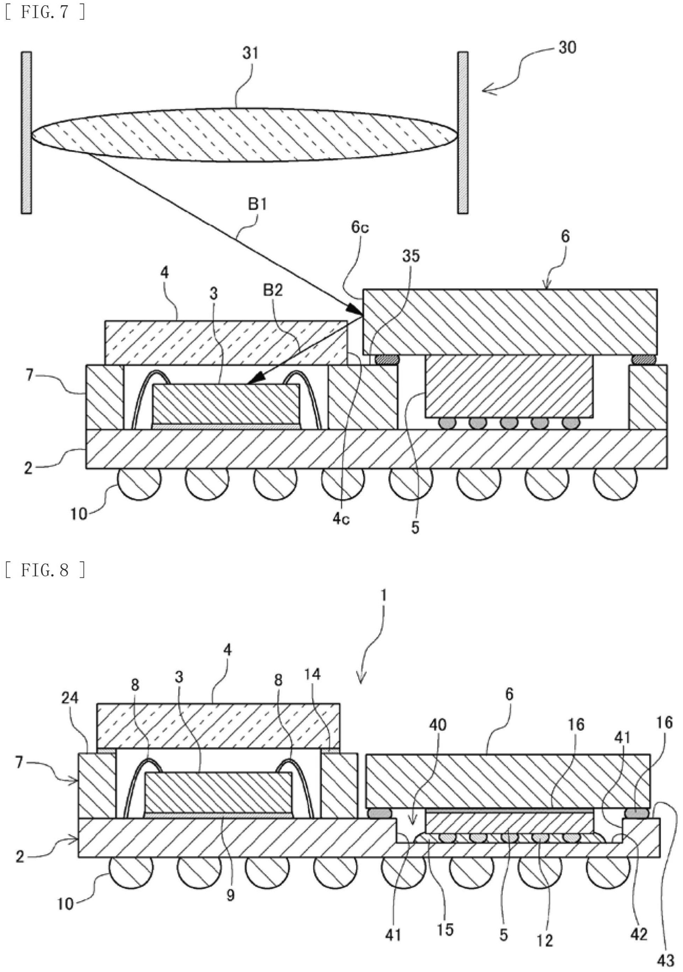

For example, FIG. 7 illustrates a configuration in which the heat dissipation lid 6 having a plate thickness larger than that of the glass 4 is mounted on a support surface 35 of the stiffener 7 at the same height position as that of the glass 4 to thereby position a top portion of the heat dissipation lid 6 above the top surface 4a of the glass 4. It is to be noted that, in FIG. 7, components corresponding to respective components of the solid-state imaging device 1 according to the present embodiment are denoted by the same reference numerals.

According to the configuration as illustrated in FIG. 7, the heat dissipation lid 6 and the glass 4 are disposed close to each other in order to downsize the package. This allows the side surface 6c of the heat dissipation lid 6 on a side of the glass 4 higher than the glass 4 to act as a light reflection surface at a position close to the glass 4, thus allowing a part of the light having passing through an optical system 30 including a lens 31 disposed above the glass 4 to easily enter the heat dissipation lid 6. Light having entered the heat dissipation lid 6 (see an arrow B1) is reflected by the side surface 6c of the heat dissipation lid 6 on the side of the glass 4 to enter the glass 4 from the side surface 4c of the glass 4 on the side of the heat dissipation lid 6, and passes through the glass 4 to enter the image sensor 3 (see an arrow B2). This may cause a defect such as flare. Here, reflected light from a portion, above the position of the top surface 4a of the glass 4, of the side surface 6c of the heat dissipation lid 6 opposed to the glass 4 enters the light-receiving region of the image sensor 3, which easily causes flare.

Accordingly, according to the configuration in which the heat dissipation lid 6 is provided at a position lower than the top surface 4a of the glass 4 as illustrated in FIG. 1, the side surface 6c on the left side of the heat dissipation lid 6 opposed to the glass 4 is present at a position lower than the top surface 4a of the glass 4. This makes it possible to reduce the reflected light from the side surface 6c of the heat dissipation lid 6 that easily causes flare and reduce light that is to enter the glass 4 from the side surface 4c on the right side, while downsizing the package by disposing the heat dissipation lid 6 and the glass 4 close to each other. As a result, it is possible to suppress flare.

In addition, according to the configuration in which the heat dissipation lid 6 is provided at a position lower than the top surface 4a of the glass 4, it is possible to suppress interference of the glass 4 with the heat dissipation lid 6 upon mounting of the glass 4 in the manufacturing process of the solid-state imaging device 1 as described above. This makes it possible to prevent pitting (chipping) or the like of the glass 4.

In addition, the solid-state imaging device 1 has a configuration in which the lid support surface 25 of the stiffener 7 is provided lower than the glass support surface 24 as a configuration for providing the heat dissipation lid 6 at a position lower than the top surface 4a of the glass 4. According to such a configuration, it is possible to easily provide a configuration in which the heat dissipation lid 6 is provided at a position lower than the glass 4 by adjusting the shape of the stiffener 7 formed by molding or the like.

### <3. Modification Examples of Solid-state Imaging Device According to First Embodiment>

Description is given of modification examples of the solid-state imaging device 1 according to the first embodiment of the present technology.

### (First Modification Example)

As illustrated in FIG. 8, in the solid-state imaging device 1 of a first modification example, a recessed portion 40 having a cavity structure is provided as a supporting structure for the heat dissipation lid 6 in a right-side portion of the substrate 2 on the side of the front surface 2a in place of support by the stiffener 7 to support the heat dissipation lid 6 on the front surface 2a of the substrate 2. That is, in a configuration of the first modification example, as compared with the configuration as illustrated in FIG. 1, the second support frame portion 22 of the stiffener 7 is omitted, and the heat dissipation lid 6 is mounted directly on the substrate 2 by disposing the LSI 5 in the recessed portion 40 of the substrate 2. In the configuration of the first modification example, the stiffener 7 includes only a portion corresponding to the first support frame portion 21.

The recessed portion 40 is opened on the front surface 2a of the substrate 2. The recessed portion 40 has a rectangular opening shape corresponding to the outer shape of the LSI 5, and is formed in a portion where the LSI 5 is to be mounted of the substrate 2. The recessed portion 40 is a hole portion having a rectangular shape in plan view formed by a surface portion including four side surfaces 41, which is formed perpendicularly to the plate surface of the substrate 2, and a horizontal bottom surface 42. The recessed portion 40 has an opening dimension larger than the outside dimension of the LSI 5, and is formed to allow the entire LSI 5 to fit in the recessed portion 40 in plan view.

In a configuration in which the substrate 2 has the recessed portion 40, the bottom surface 42 of the recessed portion 40 serves as a surface on which the LSI 5 is to be mounted by the coupling terminals 12 or the like. In addition, a portion of the front surface 2a of the substrate 2 around the recessed portion 40 serves as a lid support surface portion 43. The heat dissipation lid 6 is adhered to the lid support surface portion 43 and the top surface 5a of the LSI 5 by the adhesive 16.

It is possible to obtain the substrate 2 having the recessed portion 40 by known technology. For example, in a substrate having a multilayer structure in which sheet-like members including a ceramic material, a resin material, or the like are stacked, a through-opening portion is formed as a portion where the recessed portion 40 is to be formed in each of the stacked sheet-like members, thus making it possible to obtain the substrate 2 having the recessed portion 40.

As described above, the configuration of the first modification example has a configuration in which the recessed portion 40 for disposing the LSI 5 on the substrate 2 is provided, as a configuration for providing the heat dissipation lid 6 at a position lower than the top surface 4a of the glass 4. According to such a configuration, it is possible to easily provide a configuration in which the heat dissipation lid 6 is provided lower than the glass 4 by adjusting the shape of the substrate 2. According to the configuration of the first modification example also, it is possible to obtain workings and effects as described above. In addition, according to the configuration of the first modification example, as compared with the configuration illustrated in FIG. 1, it is possible to reduce the materials included in the stiffener 7 by the material included in the second support frame portion 22.

### (Second Modification Example)

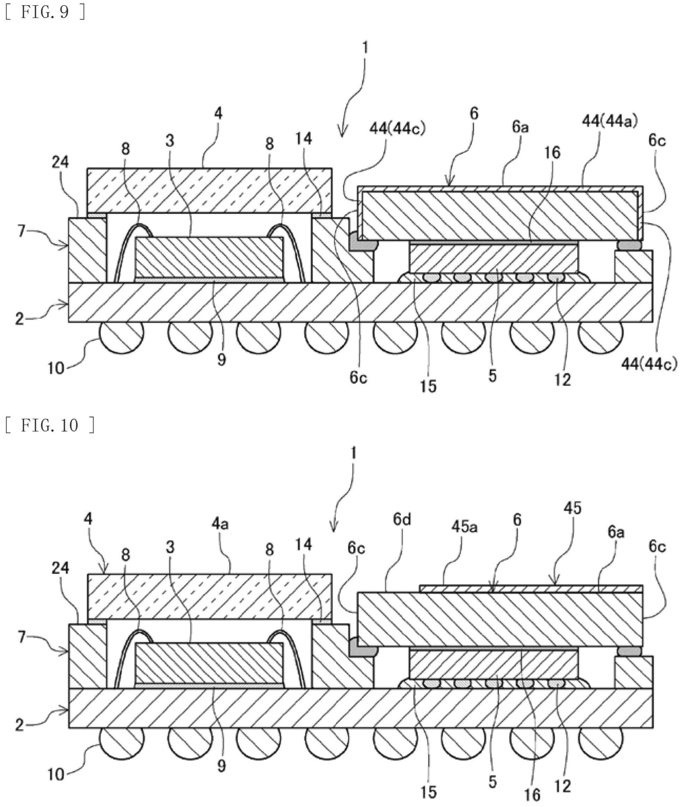

As illustrated in FIG. 9, the solid-state imaging device 1 of a second modification example has a low reflection portion 44 on a surface of the heat dissipation lid 6. That is, in a configuration of the second modification example, at least a portion of the surface of the heat dissipation lid 6 serves as the low reflection portion 44 that is less reflective to light than a portion other than the low reflection portion 44.

In an example illustrated in FIG. 9, the heat dissipation lid 6 includes the low reflection portion 44 on a side of each of the four side surfaces 6c and the top surface 6a. That is, the heat dissipation lid 6 includes, as the low reflection portions 44, a top surface low reflection portion 44a provided on the side of the top surface 6a, and a side surface low reflection portion 44c provided on the side of each of the side surfaces 6c.

The low reflection portion 44 is, for example, a portion in which a surface of the heat dissipation lid 6 is subjected to low reflection processing such as a black treatment or a matte treatment. Examples of the black treatment include black electroless plating, black dyeing, and coating with a black paint. In addition, examples of the matte treatment include a surface treatment by sand blasting or the like. In addition, the low reflection portion 44 may be, for example, a portion provided by attaching a low reflection member such as an antireflection film to a surface of a main body of the heat dissipation lid 6.

As in the configuration of the second modification example, according to the configuration in which low reflection of the heat dissipation lid 6 is achieved by using the surface of the heat dissipation lid 6 as the low reflection portion 44, it is possible to reduce reflected light from the surface of the heat dissipation lid 6, thus making it possible to effectively suppress flare. It is to be noted that in terms of reducing the reflected light from the surface of the heat dissipation lid 6 that causes flare, the low reflection portion 44 is preferably provided at least on the side surface 6c on the side of the glass 4. In addition, in a case where the low reflection portion 44 is provided on the top surface 6a of the heat dissipation lid 6, the low reflection portion 44 is provided within a range including at least an edge portion of the top surface 6a of the heat dissipation lid 6 on the side of the glass 4 (an edge portion on the left side in FIG. 9).

### (Third Modification Example)

As illustrated in FIG. 10, the solid-state imaging device 1 of a third modification example includes a heat dissipation sheet 45 that is a sheet-like heat dissipator provided on the top surface 6a of the heat dissipation lid 6. The heat dissipation sheet 45 is a flexible sheet-like member, and is provided in a state of being attached to the top surface 6a of the heat dissipation lid 6 by an adhesive or the like.

The heat dissipation sheet 45 is a sheet having a thermal conductivity (a thermal conductive sheet). The heat dissipation sheet 45 is not limited in configuration; however, a material having a higher thermal conductivity than that of the material included in the heat dissipation lid 6 is used as the heat dissipation sheet 45. As the heat dissipation sheet 45, for example, a sheet is used that has a structure in which a highly thermally conductive filler such as highly thermally conductive metal or ceramic is included in a resin sheet including an acrylic-based resin, a silicon-based resin, or the like.

The heat dissipation sheet 45 is provided to cover the entire or substantially entire top surface 6a of the heat dissipation lid 6. Meanwhile, the heat dissipation sheet 45 is configured to be provided on the heat dissipation lid 6 disposed close to the glass 4. Accordingly, for example, in a case where a height position of a top surface 45a of the heat dissipation sheet 45 is close to the height position of the top surface 4a of the glass 4 or higher than the height position of the top surface 4a, the heat dissipation sheet 45 is provided to be spaced apart from the glass 4 in terms of preventing a portion that reflects light causing flare from being positioned close to the glass 4.

Specifically, as illustrated in FIG. 10, the heat dissipation sheet 45 is provided at a position away from the side surface 6c on the left side of the heat dissipation lid 6 to the right so as to cause a portion of the top surface 6a of the heat dissipation lid 6 on the side of the glass 4 to be an exposed portion 6d. As described above, in order to prevent the heat dissipation sheet 45 from being positioned close to the glass 4, the heat dissipation sheet 45 may be partially provided to cover a portion other than the portion on the side of the glass 4 of the top surface 6a of the heat dissipation lid 6. The heat dissipation sheet 45 is provided so as to cause, for example, a range of the exposed portion 6d to be equal to or less than a half of the entire dimension of the heat dissipation lid 6 in the right-left direction. It is to be noted that in a case where a thickness of the heat dissipation sheet 45 is relatively thin and the height position of the top surface 45a of the heat dissipation sheet 45 is sufficiently lower than the height position of the top surface 4a of the glass 4, the heat dissipation sheet 45 may be provided to reach a left edge end of the top surface 6a of the heat dissipation lid 6, that is, not to form the exposed portion 6d.

According to a configuration of the third modification example, it is possible to improve heat dissipation characteristics while suppressing flare caused by the reflected light from the heat dissipation lid 6. That is, providing the heat dissipation sheet 45 on the heat dissipation lid 6 makes it possible to efficiently dissipate heat generated from the LSI 5 and the image sensor 3 that are heating elements, as compared with a case of providing the heat dissipation lid 6 alone, and makes it possible to improve heat dissipation characteristics of the solid-state imaging device 1. In addition, providing the heat dissipation sheet 45 at a position away from the side of the glass 4, that is, securing the exposed portion 6d of the top surface 6a of the heat dissipation lid 6 makes it possible to reduce an influence of heat dissipated from the heat dissipation sheet 45 on the image sensor 3 while reducing reflected light from the heat dissipation sheet 45 to the side of the image sensor 3.

### (Fourth Modification Example)

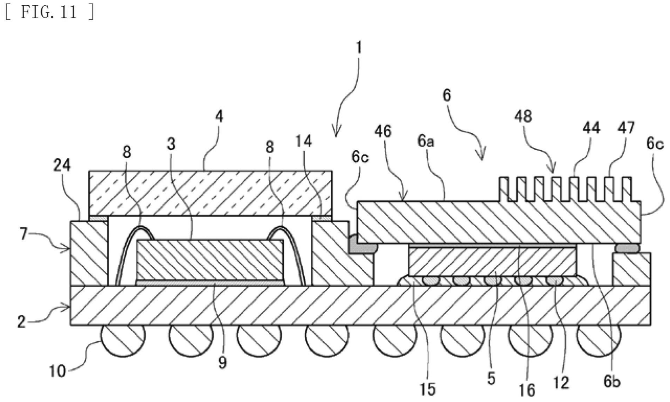

As illustrated in FIG. 11, in the solid-state imaging device 1 of a fourth modification example, the heat dissipation lid 6 includes a heat dissipation fin portion 48 including fins 47 that are a plurality of protrusion portions. That is, in the fourth modification example, the heat dissipation lid 6 includes a heat dissipation member main body portion 46 that is positioned on the LSI 5, and a plurality of fins 47 that each protrudes from the heat dissipation member main body portion 46.

The heat dissipation member main body portion 46 is a portion having a rectangular plate-shaped outer shape, and the LSI 5 is adhered to the heat dissipation member main body portion 46 through the adhesive 16 on a side of the bottom surface 6b. The fin 47 is a thin plate-shaped portion that protrudes upward from the top surface 6a. The plurality of fins 47 is provided at predetermined intervals and forms a comb-like shape in side view.

The heat dissipation fin portion 48 is a portion provided on the upper side of the heat dissipation lid 6 disposed close to the glass 4. Accordingly, for example, in a case where the height positions of upper ends of the plurality of fins 47 are close to the height position of the top surface 4a of the glass 4, the heat dissipation fin portion 48 is provided to be spaced apart from the glass 4 in terms of preventing a portion that reflects light causing flare from being positioned close to the glass 4.

Specifically, as illustrated in FIG. 11, the heat dissipation fin portion 48 is provided at a position away from the side surface 6c on the left side of the heat dissipation lid 6 to the right so as to cause a portion of the top surface 6a of the heat dissipation lid 6 on the side of the glass 4 to be a portion where the heat dissipation fin portion 48 is not formed. The heat dissipation fin portion 48 is formed, for example, within a range equal to or less than a half of the heat dissipation lid 6 on an anti-glass side (the right side) in the right-left direction.

According to a configuration of the fourth modification example, it is possible to improve the heat dissipation characteristics while suppressing flare caused by the reflected light from the heat dissipation lid 6. That is, providing the heat dissipation fin portion 48 in the heat dissipation lid 6 makes it possible to increase a surface area of the heat dissipation lid 6 and thus improve a heat dissipation action. As a result, it is possible to efficiently dissipate heat generated from the LSI 5 and the image sensor 3 that are heating elements, and it is possible to improve the heat dissipation characteristics of the solid-state imaging device 1. In addition, providing the heat dissipation fin portion 48 at a position away from the side of the glass 4 makes it possible to reduce an influence of heat dissipated from the heat dissipation fin portion 48 on the image sensor 3 while reducing reflected light from the heat dissipation fin portion 48 to the side of the image sensor 3.

It is to be noted that the shapes, the arrangement intervals, and the like of the fins 47 of the heat dissipation fin portion 48 are not limited. In addition, the heat dissipation fin portion 48 may be formed on the side surface 6c of the heat dissipation lid 6. In addition, the plurality of protrusion portions may be protrusion portions that each allow for an increase in surface area of the heat dissipation lid 6, and, for example, a plurality of columnar or rod-shaped protruding portions may be provided as the plurality or protrusion portions.

### <4. Configuration Example of Solid-state Imaging Device According to Second Embodiment>

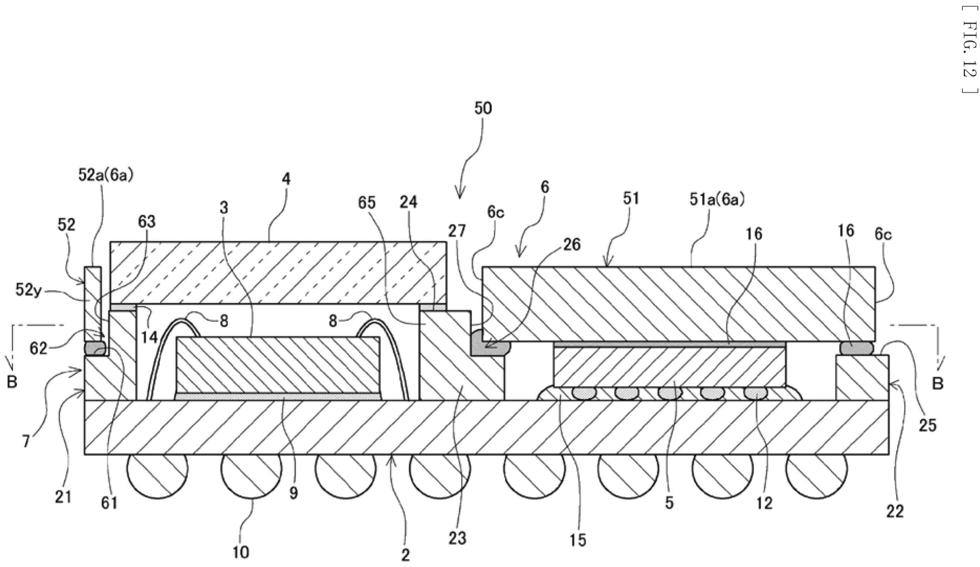

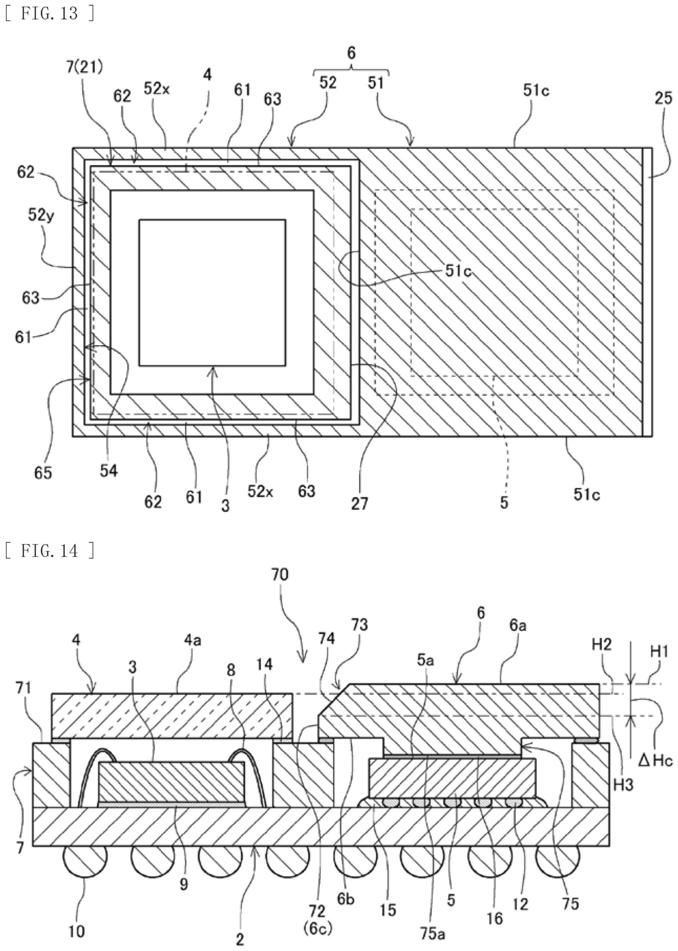

Description is given, with reference to FIGs. 12 and 13, of a solid-state imaging device 50 according to a second embodiment of the present technology. FIG. 13 is a plane cross-sectional view at a position B-B of FIG. 12. In each of embodiments described below, components that are the same as or corresponding to those of the first embodiment are denoted by the same names or the same reference numerals to avoid any redundant description as appropriate.

The present embodiment is different from the first embodiment in that the heat dissipation lid 6 includes an extending portion toward the side of the image sensor 3. As illustrated in FIGs. 12 and 13, the heat dissipation lid 6 according to the present embodiment includes a heat dissipation member main body portion 51 that is positioned on the LSI 5, and a heat dissipation member extending portion 52 that extends from the heat dissipation member main body portion 51 to a region where the image sensor 3 is disposed in plan view.

The heat dissipation member main body portion 51 is a portion corresponding to the heat dissipation lid 6 according to the first embodiment. The heat dissipation member main body portion 51 has the same or substantially same dimension as that of the substrate 2 in the substrate short-side direction (in the up-down direction in FIG. 13), and side surfaces 51c on both sides in the substrate short-side direction are aligned with the side surfaces 2c of the substrate 2 in plan view.

The heat dissipation member extending portion 52 is a portion extending from the heat dissipation member main body portion 51 to the side of the image sensor 3 (the left side) so as to cause a dimension in the up-down direction of the entire heat dissipation lid 6 to be constant while maintaining a thickness dimension of the heat dissipation member main body portion 51 in the up-down direction. Accordingly, in the heat dissipation lid 6, the top surfaces 51a and 52a of the heat dissipation member main body portion 51 and the heat dissipation member extending portion 52 that form the top surface 6a of the heat dissipation lid 6 each have a constant height lower by the dimension of the difference ΔHa (see FIG. 1) than the top surface 4a of the glass 4.

In the present embodiment, the heat dissipation member extending portion 52 is provided to surround the image sensor 3 in plan view. The heat dissipation member extending portion 52 is provided along an outer edge of the first support frame portion 21 of the stiffener 7, and includes lateral side portions 52x that extend linearly from both ends in the substrate short-side direction of the heat dissipation member main body portion 51 toward the left, and a vertical side portion 52y that couples left end portions of the lateral side portions 52x on both sides to each other. The vertical side portion 52y is formed linearly along an edge on the left side of the stiffener 7.

The heat dissipation member extending portion 52 is formed in a frame shape along an outer shape of substantially a half of the substrate 2 on the left side in plan view. The heat dissipation member extending portion 52 forms an opening portion 54 having a rectangular shape in plan view by inner side surfaces of the lateral side portions 52x on both sides in the substrate short-side direction, an inner side surface of the vertical side portion 52y, and the side surface 51c on the left side of the heat dissipation member main body portion 51. The opening portion 54 has an opening dimension larger than an outside dimension of the glass 4 in plan view, and is provided so as to cause the entire glass 4 to be positioned within an opening range in plan view. The lateral side portions 52x and the vertical side portion 52y each have a rectangular cross-sectional shape having a long side in the up-down direction, and are provided to form a peripheral wall portion surrounding a lower portion of the glass 4 together with the heat dissipation member main body portion 51.

In a configuration in which the heat dissipation lid 6 includes the heat dissipation member main body portion 51 and the heat dissipation member extending portion 52, the stiffener 7 has a lid extending portion support surface 61 for supporting the heat dissipation member extending portion 52 around the glass 4. The lid extending portion support surface 61 is formed, corresponding to the lateral side portions 52x and 52x, and the vertical side portion 52y, on an outer peripheral side of both side portions in the substrate short-side direction and the side portion on the left side of the first support frame portion 21 of the stiffener 7.

The lid extending portion support surface 61 is formed at a low position to form a step portion 62 with respect to the glass support surface 24, and is positioned at the same height as that of the lid support surface 25. The step portion 62 has a step surface 63 that couples the glass support surface 24 and the lid extending portion support surface 61 to each other. The step surface 63 is formed as a surface along the up-down direction to form a right angle with each of the glass support surface 24 and the lid extending portion support surface 61 in cross-sectional view as illustrated in FIG. 12.

In a portion on the left side of the stiffener 7 having such a configuration, a protruding portion 65 that forms the glass support surface 24 is formed by the step portion 26 in the intermediate side portion 23 and the step portion 62 along three side portions of the heat dissipation member extending portion 52. The protruding portion 65 is a portion forming an opening portion closed by the glass 4, and is a portion formed as a protruding portion relative to a lower portion by the step portions 26 and 62. The protruding portion 65 is a portion having a rectangular frame shape in plan view with the glass support surface 24 as a top surface thereof.

The heat dissipation lid 6 is supported by the stiffener 7 in such a manner that the protruding portion 65 of the stiffener 7 is fitted into the opening portion 54. The heat dissipation lid 6 is fixedly supported by the stiffener 7 by adhering the heat dissipation member main body portion 51 to the lid support surface 25 by the adhesive 16 and adhering each side portion of the heat dissipation member extending portion 52 to the lid extending portion support surface 61 by the adhesive 16.

According to the solid-state imaging device 50 according to the present embodiment, it is possible to improve the heat dissipation characteristics while suppressing flare caused by the reflected light from the heat dissipation lid 6. That is, the heat dissipation lid 6 includes the heat dissipation member extending portion 52, which makes it possible to dispose a portion of the heat dissipation lid 6 around the image sensor 3. As a result, it is possible to efficiently dissipate heat generated from the image sensor 3 that is a heating element, and it is possible to improve heat dissipation characteristics of the solid-state imaging device 50.

In addition, the heat dissipation member extending portion 52 includes the lateral side portions 52x and 52x and the vertical side portion 52y, and is provided to surround the image sensor 3 in plan view with these side portions. According to such a configuration, it is possible to dispose a portion of the heat dissipation lid 6 over an entire periphery of the image sensor 3, which makes it possible to effectively improve the heat dissipation characteristics.

It is to be noted that the shape of the heat dissipation member extending portion 52 is not limited to that in the present embodiment. The heat dissipation member extending portion 52 may have, for example, a configuration including only the lateral side portions 52x on both sides in the substrate short-side direction. In addition, the heat dissipation member extending portion 52 may be a portion having a dimension in the up-down direction different from a plate thickness dimension of the heat dissipation member main body portion 51. However, the heat dissipation member extending portion 52 is provided so as to cause the top surface 52a that forms the top surface 6a of the heat dissipation lid 6 together with the top surface 51a of the heat dissipation member main body portion 51 to be positioned at a height lower than the top surface 4a of the glass 4.

### <5. Configuration Example of Solid-state Imaging Device According to Third Embodiment>

Description is given, with reference to FIG. 14, of a solid-state imaging device 70 according to a third embodiment of the present technology.

The heat dissipation lid 6 according to the present embodiment has a configuration in which a portion positioned above the top surface 4a of the glass 4 is included and in the side portion on the side of the glass 4, a height of the side surface 6c on the side of the glass 4 is positioned lower than the top surface 4a of the glass 4.

As illustrated in FIG. 14, the heat dissipation lid 6 has a plate thickness larger than the plate thickness of the glass 4, and is supported relative to the stiffener 7 by a support surface positioned at the same height as that of the support surface for the glass 4. That is, the stiffener 7 according to the present embodiment has, as the top surface, a support surface 71 including the glass support surface 24 and the lid support surface 25 (see FIG. 1) that are continuous with each other at the same height position.

In such a configuration, the height position H1 of the top surface 6a of the heat dissipation lid 6 having a plate thickness thicker than that of the glass 4 is higher than the height position H2 of the top surface 4a of the glass 4. Furthermore, the heat dissipation lid 6 has an opposed side surface 72 opposed to the glass 4, and the opposed side surface 72 is formed at a position lower than the top surface 4a of the glass 4.

The opposed side surface 72 is the side surface 6c on the left side of the heat dissipation lid 6. The opposed side surface 72 is provided to cause a height position H3 of an upper end thereof to be lower than the height position H2 of the top surface 4a of the glass 4.

The heat dissipation lid 6 includes a chamfered portion 73 in an upper corner portion on the side of the glass 4 (the left side) as a configuration for disposing the upper end of the opposed side surface 72 lower than the top surface 4a of the glass 4. The chamfered portion 73 may be formed in an entire range of an upper left corner portion of the heat dissipation lid 6 in the substrate short-side direction, or may be formed in an intermediate portion excluding both end portions in the substrate short-side direction of the upper left corner portion.

The chamfered portion 73 forms an inclined surface 74 extending downward from the right side to the left side. The inclined surface 74 is a surface between an upper end of the opposed side surface 72 and a left end of the top surface 6a, and a height of an edge portion on the left side of the heat dissipation lid 6 gradually decreases from the right side to the left side. The heat dissipation lid 6 has the inclined surface 74, which causes a height position of the left end of the heat dissipation lid 6, that is, a height position of the upper end of the opposed side surface 72 to be lower than the height position H1 of the top surface 6a of the heat dissipation lid 6 by a range ΔHc where the inclined surface 74 is formed in the up-down direction. For example, the height position H3 of the upper end of the opposed side surface 72 is set to be lower than the height position of the middle of the glass 4 in the plate thickness direction. It is to be noted that an inclination angle of the inclined surface 74 and a range where the inclined surface 74 is formed in the right-left direction are not particularly limited. In the illustrated example, the inclination angle of the inclined surface 74 with respect to the up-down direction is about 45°.

In addition, in the present embodiment, the heat dissipation lid 6 has, on the side of the bottom surface 6b, a protrusion 75 for contacting the top surface 5a of the LSI 5 mounted on the substrate 2 in accordance with the dimension in the up-down direction of the LSI 5. The protrusion 75 is a portion partially protruding downward of the heat dissipation lid 6 on the side of the bottom surface 6b, and is a portion in which a contact surface 75a that contacts the top surface 5a of the LSI 5 through the adhesive 16 is formed at a position lower than the bottom surface 6b in accordance with a size of a gap between the top surface 5a of the LSI 5 and the bottom surface 6b of the heat dissipation lid 6. That is, the contact surface 75a serves as an adhesive surface by the adhesive 16 with respect to the top surface 5a of the LSI 5.

The protrusion 75 is provided so as to cause the contact surface 75a to contact most of the top surface 5a of the LSI 5 or the entire top surface 5a of the LSI 5. The protrusion 75 is formed as a portion having a rectangular shape in bottom view along the outer shape of the LSI 5. However, the shape of the protrusion 75 is not particularly limited. In addition, the protrusion 75 may be provided at each of a plurality of positions as contact portions to the top surface 5a of the LSI 5.

According to the solid-state imaging device 70 according to the present embodiment, as in the first embodiment, it is possible to suppress occurrence of flare caused by the reflected light from the heat dissipation lid 6 while downsizing the device configuration. That is, according to a configuration in which the opposed side surface 72 of the heat dissipation lid 6 is formed at a position lower than the top surface 4a of the glass 4, it is possible to reduce the reflected light from the side surface 6c of the heat dissipation lid 6 that easily causes flare and reduce light that is to enter the glass 4 from the side surface 4c on the right side while downsizing the package by disposing the heat dissipation lid 6 and the glass 4 close to each other. As a result, it is possible to suppress flare.

In addition, according to a configuration in which the opposed side surface 72 of the heat dissipation lid 6 is formed at a position lower than the top surface 4a of the glass 4, it is possible to suppress interference of the glass 4 with the heat dissipation lid 6 in a manufacturing process of the solid-state imaging device as described above. This makes it possible to prevent pitting or the like of the glass 4.

In addition, the solid-state imaging device 70 includes the chamfered portion 73 in the corner portion of the heat dissipation lid 6 on the side of the glass 4 as a configuration for forming the opposed side surface 72 of the heat dissipation lid 6 at a position lower than the top surface 4a of the glass 4. According to such a configuration, it is possible to adopt a relatively simple shape for the stiffener 7, and it is possible to easily provide a configuration in which the opposed side surface 72 of the heat dissipation lid 6 is formed at a low position with respect to the glass 4 by adjusting the shape of the heat dissipation lid 6.

As in the solid-state imaging device 70 according to the present embodiment, in the heat dissipation lid 6, the opposed side surface 72, which is at least a side surface on a side opposed to the glass 4, is provided at a position lower than the top surface 4a of the glass 4, which makes it possible to suppress occurrence of flare caused by the reflected light from the heat dissipation lid 6 while downsizing the device configuration.

### <6. Modification Example of Solid-state Imaging Device According to Third Embodiment>

Description is given of a modification example of the solid-state imaging device 70 according to the third embodiment of the present technology.

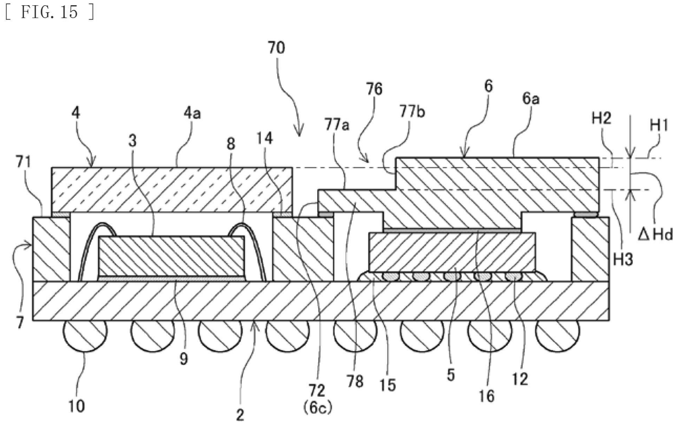

As illustrated in FIG. 15, in a configuration of this modification example, the heat dissipation lid 6 includes a notch portion 76 on the upper side on the side of the glass 4 (the left side) as a configuration for disposing the upper end of the opposed side surface 72 lower than the top surface 4a of the glass 4. The notch portion 76 may be formed in an entire range of an upper left portion of the heat dissipation lid 6 in the substrate short-side direction,, or may be formed in an intermediate portion excluding both end portions in the substrate short-side direction of the upper left portion.

The notch portion 76 forms a right-angled step portion by a horizontal transverse surface 77a and a vertical longitudinal surface 77b. The transverse surface 77a is a surface between the upper end of the opposed side surface 72 and a lower end of the longitudinal surface 77b, and the longitudinal surface 77b is a surface between a right end of the transverse surface 77a and a left end of the top surface 6a. In the heat dissipation lid 6, a portion provided with the notch portion 76 is a thin plate portion 78 having a thin plate thickness with respect to another portion (a portion not provided with the notch portion 76).

The heat dissipation lid 6 has the notch portion 76, which causes the height position H3 of the upper end of the opposed side surface 72 to be lower than the height position H1 of the top surface 6a of the heat dissipation lid 6 by a range ΔHd where the notch portion 76 is formed in the up-down direction. It is to be noted that the shape of the notch portion 76 (e.g., an angle formed by the transverse surface 77a and the longitudinal surface 77b in side cross-sectional view) and a range where the notch portion 76 is formed in the right-left direction are not particularly limited.

According to the configuration of this modification example, as in the configuration in which the heat dissipation lid 6 includes the chamfered portion 73 as illustrated in FIG. 14, it is possible to easily provide a configuration in which while the stiffener 7 has a relatively simple shape, the heat dissipation lid 6 has the opposed side surface 72 lower than the glass 4. In addition, according to the configuration of this modification example, as compared with the configuration in which the heat dissipation lid 6 includes the chamfered portion 73, a portion above a portion in which the opposed side surface 72 is formed is a space portion (a recessed portion) by the notch portion 76, which makes it possible to effectively reduce reflected light to the side of the image sensor 3 that causes flare.

### <7. Configuration Example of Solid-state Imaging Device According to Fourth Embodiment>

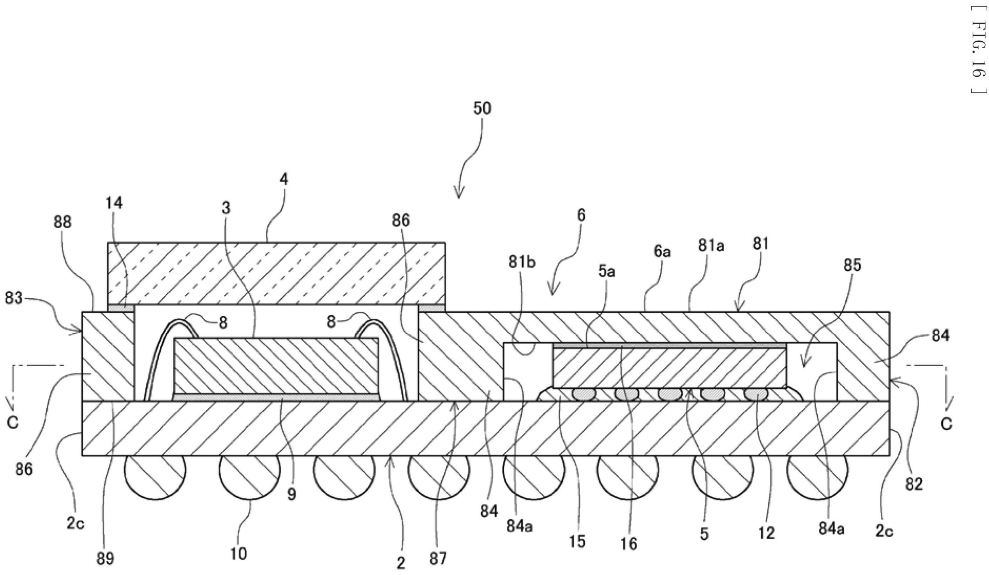

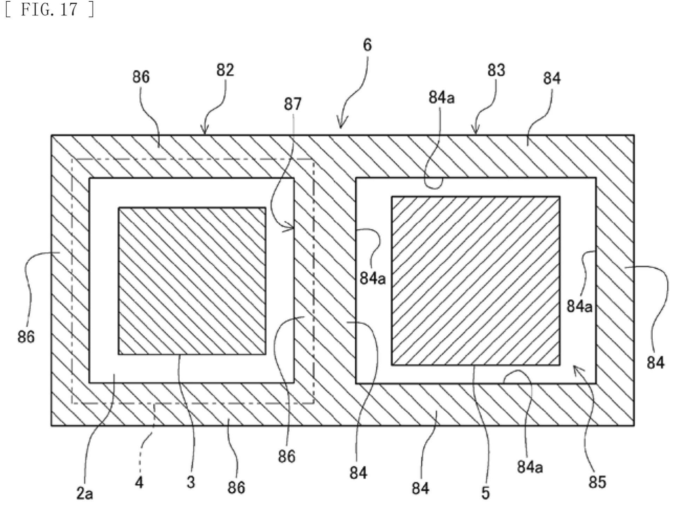

Description is given, with reference to FIGs. 16 and 17, of a configuration example of a solid-state imaging device 80 according to a fourth embodiment of the present technology. FIG. 17 is a plane cross-sectional view at a position C-C of FIG. 16.

The present embodiment is different from the first embodiment in that the stiffener 7 is not included and a support frame portion that supports the glass 4 is integrated with the heat dissipation lid 6. As illustrated in FIGs. 16 and 17, the heat dissipation lid 6 according to the present embodiment includes a heat dissipation member main body portion 81 that is positioned on the LSI 5, a light-transmissive member support portion 82, and a peripheral wall portion 83. The light-transmissive member support portion 82 extends from the heat dissipation member main body portion 81 to a region where the image sensor 3 is disposed in plan view to support the glass 4 relative to the substrate 2. The peripheral wall portion 83 is provided around the heat dissipation member main body portion 81. The heat dissipation member main body portion 81, the light-transmissive member support portion 82, and the peripheral wall portion 83 constitute the integral heat dissipation lid 6.

The heat dissipation member main body portion 81 is a portion corresponding to the heat dissipation lid 6 according to the first embodiment, and is a plate-shaped portion having a predetermined thickness. The heat dissipation member main body portion 81 has a top surface 81a forming a portion of the top surface 6a of the heat dissipation lid 6, and a bottom surface 81b serving as an adhesive surface to the top surface 5a of the LSI 5 through the adhesive 16.

The peripheral wall portion 83 is provided to surround a periphery of the LSI 5. The peripheral wall portion 83 is formed as a rectangular frame-shaped portion along an outer shape of substantially a half of the substrate 2 on the right side in plan view, and includes four linear wall portions 84 that form a rectangular frame shape in plan view. The wall portions 84 each have a rectangular outer shape in cross-sectional view.

The peripheral wall portion 83 forms a box-shaped portion in which a lower side is an opening side, together with the heat dissipation member main body portion 81. The LSI 5 on the substrate 2 is housed inside the box-shaped portion formed by the heat dissipation member main body portion 81 and the peripheral wall portion 83. That is, the heat dissipation member main body portion 81 and the peripheral wall portion 83 form a space portion 85 in which the LSI 5 is housed on the front surface 2a of the substrate 2. The space portion 85 is a rectangular parallelepiped space portion formed by the bottom surface 81b of the heat dissipation member main body portion 81 and inner wall surfaces 84a of the four wall portions 84.

The light-transmissive member support portion 82 is a portion extending to the side of the image sensor 3 (the left side) so as to cause the dimension in the up-down direction of the entire heat dissipation lid 6 to be constant while maintaining a thickness dimension of a portion on the right side of the heat dissipation lid 6 constituted by the heat dissipation member main body portion 81 and the peripheral wall portion 83 in the up-down direction.

The light-transmissive member support portion 82 is provided to surround the image sensor 3 in plan view. The light-transmissive member support portion 82 is formed as a rectangular frame-shaped portion along an outer shape of substantially a half of the substrate 2 on the left side in plan view, and includes four support wall portions 86 that form a rectangular frame shape in plan view. The support wall portions 86 each have a rectangular outer shape in cross-sectional view. The light-transmissive member support portion 82 is opened on both the upper and lower sides.

The light-transmissive member support portion 82 forms an integral intermediate wall portion 87 by coupling the support wall portion 86 on the right side among the four support wall portions 86 to the wall portion 84 on the left side of the peripheral wall portion 83. That is, the intermediate wall portion 87 in which wall portions adjacent to each other of the light-transmissive member support portion 82 and the peripheral wall portion 83 are coupled to each other is formed in a substantially middle portion in the right-left direction of the heat dissipation lid 6.

A top surface of the light-transmissive member support portion 82 serves as a glass support surface 88 on which the glass 4 is attached. The glass support surface 88 is a surface formed by top surfaces of the four support wall portions 86 of the light-transmissive member support portion 82, and has a rectangular frame shape in plan view. The glass support surface 88 is a surface that is continuous with the top surface 81a of the heat dissipation member main body portion 81, and forms, together with the top surface 81a, a flat surface positioned on a predetermined virtual plane perpendicular to the up-down direction.

The glass support surface 88 is contacted with the outer edge portion of the bottom surface 4b of the glass 4 through the adhesive 14 to support the glass 4. When the glass 4 is fixed to the glass support surface 88 by the adhesive 14 so as to cause an entire rectangular opening portion on the upper side of the light-transmissive member support portion 82 to be closed by the glass 4, thus causing the image sensor 3 on the substrate 2 to be in a state of being sealed with the glass 4 and the light-transmissive member support portion 82 of the heat dissipation lid 6. The glass support surface 88 causes the entire glass 4 to be positioned within the range of the outer shape in plan view, and the four side surfaces 4c of the glass 4 are each positioned on the glass support surface 88.

The heat dissipation lid 6 has the dimension of the entire outer shape in plan view that is the same or substantially the same as that of the substrate 2, and is provided to align the outer shape thereof with the outer shape of the substrate 2 in plan view. That is, the heat dissipation lid 6 is provided so as to cause four side surfaces thereof to be continuous with the side surface 2c of the substrate 2 on a same plane. However, the heat dissipation lid 6 may be provided so as to cause each of the side surfaces thereof to be positioned inside or outside the side surface 2c of the substrate 2. In addition, the heat dissipation lid 6 has a bottom surface 89 serving as an adhesive surface to the substrate 2 in the light-transmissive member support portion 82 and the peripheral wall portion 83, and is fixed to the substrate 2 by adhering the bottom surface 89 to the front surface 2a of the substrate 2 by an adhesive or the like.

According to the solid-state imaging device 80 according to the present embodiment, it is possible to improve the heat dissipation characteristics while suppressing flare caused by the reflected light from the heat dissipation lid 6. That is, a height position of the glass support surface 88 is the height position of the top surface 6a; therefore, the heat dissipation lid 6 according to the present embodiment is provided at a position lower than the bottom surface 4b of the glass 4. According to such a configuration, in the heat dissipation lid 6, it is possible to eliminate a portion that reflects light causing flare in the vicinity of the glass 4, which makes it possible to reduce light that is to enter the glass 4 from the side surface 4c on the right side, and makes it possible to effectively suppress flare.

In addition, the heat dissipation lid 6 includes the light-transmissive member support portion 82, which makes it possible to dispose a portion of the heat dissipation lid 6 so as to surround the image sensor 3. As a result, it is possible to efficiently dissipate heat generated from the image sensor 3 that is a heating element. In addition, the heat dissipation lid 6 is provided in direct contact with the substrate 2, which makes it possible to efficiently dissipate the heat of the substrate 2. Accordingly, it is possible to improve heat dissipation characteristics of the solid-state imaging device 80.

In addition, it is possible to simplify the configuration of the solid-state imaging device 80 by a configuration without the stiffener 7. In addition, it is possible to omit a process of providing the stiffener 7 in a manufacturing process of the solid-state imaging device 80, which makes it possible to simplify the manufacturing process.

### <8. Configuration Example of Solid-state Imaging Device According to Fifth Embodiment>

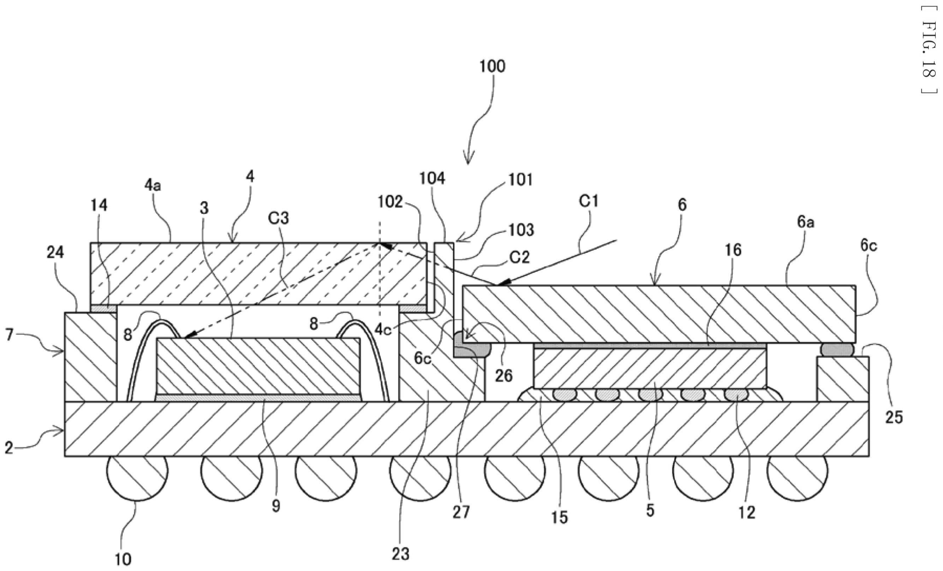

Description is given, with reference to FIG. 18, of a solid-state imaging device 100 according to a fifth embodiment of the present technology.

The solid-state imaging device 100 according to the present embodiment is different from the first embodiment in that a light-blocking wall 101 is included as a light-blocking portion interposed between the glass 4 and the heat dissipation lid 6. The light-blocking wall 101 is provided as a portion of the stiffener 7. That is, the stiffener 7 includes a material having a light blocking property, and the light-blocking wall 101 is formed as a portion positioned between the glass 4 and the heat dissipation lid 6.

The light-blocking wall 101 is formed on the upper side of the intermediate side portion 23 in the stiffener 7 along the substrate short-side direction. The light-blocking wall 101 may be formed in an entire range between the glass 4 and the heat dissipation lid 6 in the substrate short-side direction, or may be formed in an intermediate portion excluding both end portions in the substrate short-side direction of the range between the glass 4 and the heat dissipation lid 6. The light-blocking wall 101 has a glass-side wall surface 102 opposed to the side surface 4c on the right side of the glass 4, a lid-side wall surface 103 opposed to the side surface 6c on the left side of the heat dissipation lid 6, and a top surface 104.

The glass-side wall surface 102 is formed as a surface perpendicular to the glass support surface 24 to form a right angle with the glass support surface 24 in side cross-sectional view (in cross-sectional view of the intermediate side portion 23) as illustrated in FIG. 18. The glass-side wall surface 102 is formed with a slight gap between the glass-side wall surface 102 and the side surface 4c on the right side of the glass 4. However, the glass-side wall surface 102 may be a surface that contacts the side surface 4c on the right side of the glass 4.

The lid-side wall surface 103 is a wall surface on a side opposite to the glass-side wall surface 102. In an example illustrated in FIG. 18, the lid-side wall surface 103 is formed as a surface continuous with the upper side of the step surface 27 to be made flush with the step surface 27 of the step portion 26. The lid-side wall surface 103 is formed with a slight gap between the lid-side wall surface 103 and the side surface 6c on the left side of the heat dissipation lid 6. However, the lid-side wall surface 103 may be a surface that contacts the side surface 6c on the left side of the heat dissipation lid 6.

The top surface 104 is a surface between an upper end of the glass-side wall surface 102 and an upper end of the lid-side wall surface 103, and is an upper end surface of the light-blocking wall 101. The top surface 104 is formed as, for example, a horizontal surface.

In a configuration in which the heat dissipation lid 6 is disposed at a position lower than the top surface 4a of the glass 4, the light-blocking wall 101 is formed to have a height that covers most of the side surface 4c on the right side of the glass 4 in the up-down direction. Preferably, the light-blocking wall 101 is formed to cover the entire or substantially entire side surface 4c on the right side of the glass 4 in the up-down direction.

In the example illustrated in FIG. 18, the light-blocking wall 101 is formed so as to cause the top surface 104 to be positioned at the same height as the top surface 4a of the glass 4 and cover the entire side surface 4c on the right side of the glass 4. The light-blocking wall 101 may be provided so as to cause the top surface 104 to be positioned at a position higher than the top surface 4a of the glass 4.

In a case where the stiffener 7 is a portion formed by molding using a molding die, the light-blocking wall 101 is formed as a mold-shaped portion using a mold. In addition, in a case where the stiffener 7 is a portion provided by attaching a frame member including a resin material or the like to the substrate 2, the light-blocking wall 101 is provided as a portion of the frame member. According to a configuration in which the light-blocking wall 101 is provided as a portion integral with the stiffener 7 as described above, it is possible to easily provide the light-blocking wall 101 without increasing the number of processes. It is to be noted that the light-blocking wall 101 may be provided by fixing a member separate from the stiffener 7 to the glass support surface 24 or the like of the stiffener 7 by an adhesive or the like.

According to the solid-state imaging device 100 according to the present embodiment, as in the first embodiment, it is possible to suppress occurrence of a defect such as flare caused by the reflected light from the heat dissipation lid 6 while downsizing the device configuration.

As illustrated in FIG. 18, in a configuration in which the top surface 6a of the heat dissipation lid 6 is made lower than the top surface 4a of the glass 4, light having entered the top surface 6a of the heat dissipation lid 6 from an upper right side (see an arrow C1) is reflected by the top surface 6a to enter the glass 4 from the side surface 4c on the right side (see arrow C2), and is reflected by the top surface 4a of the glass 4 to enter the image sensor 3 (see an arrow C3). This may cause a defect such as flare.

Accordingly, providing the light-blocking wall 101 interposed between the glass 4 and the heat dissipation lid 6 makes it possible to block, by the light-blocking wall 101, the reflected light (see the arrow C2) from the top surface 6a of the heat dissipation lid 6 that causes flare. This makes it possible to reduce light that is to enter the glass 4 from the side surface 4c on the right side, thus making it possible to suppress flare. It is to be noted that the solid-state imaging device 100 according to the present embodiment is also applicable to a configuration in which a portion or all of the heat dissipation lid 6 is positioned at a position higher than the top surface 4a of the glass 4.

### <9. Modification Examples of Solid-state Imaging Device According to Fifth Embodiment>

Description is given of modification examples of the solid-state imaging device 100 according to the fifth embodiment of the present technology. The modification examples are modification examples about the shape of the light-blocking wall 101.

### (First Modification Example)

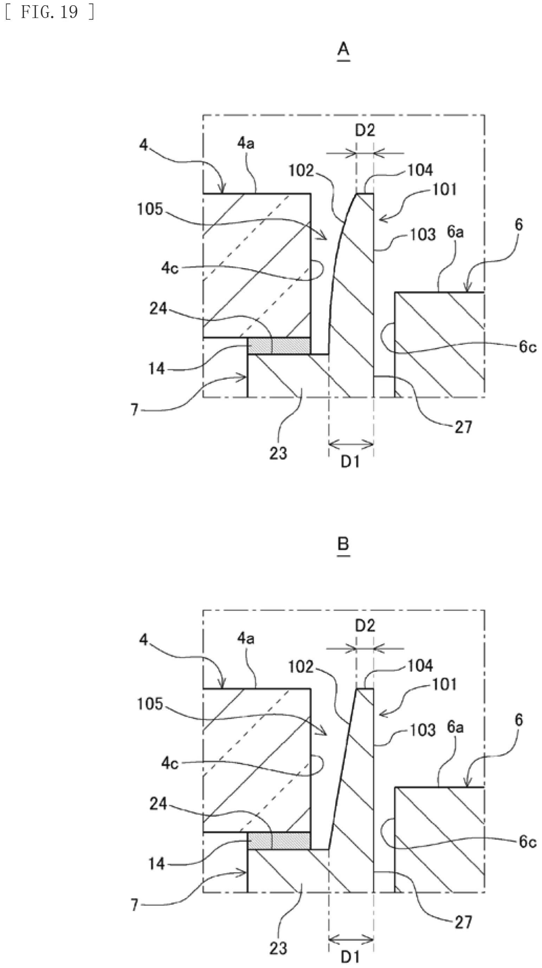

As illustrated in FIG. 19A, in a configuration of a first modification example, the light-blocking wall 101 has a shape in which a wall thickness is gradually decreased from the lower side to the upper side by forming the glass-side wall surface 102 as a curved surface. That is, the light-blocking wall 101 has a wall thickness gradually decreased from a wall thickness D1 of a base end at the height position of the glass support surface 24 to a wall thickness D2 of an upper end by a curved shape of the glass-side wall surface 102.

In the embodiment illustrated in FIG. 19A, the glass-side wall surface 102 is a protruding surface forming a gently protruding curved line in cross-sectional view (in side cross-sectional view) of the light-blocking wall 101. In addition, the wall thickness D2 of the upper end of the light-blocking wall 101 is a dimension of substantially a half of the wall thickness D1 of the base end. As in the present modification example, in a configuration in which the wall thickness of the light-blocking wall 101 is gradually decreased from the lower side to the upper side by the curved shape of the glass-side wall surface 102, a gap 105 between the side surface 4c on the right side of the glass 4 and the glass-side wall surface 102 is gradually increased from the lower side to the upper side in accordance with a decrease in the wall thickness of the light-blocking wall 101.

According to the configuration of the first modification example, it is possible to suppress interference of the glass 4 with the light-blocking wall 101 upon mounting of the glass 4 in the manufacturing process of the solid-state imaging device as described above. That is, the glass-side wall surface 102 is positioned on the side of the heat dissipation lid 6 so as to gradually decrease the wall thickness of the light-blocking wall 101 from the lower side to the upper side, which makes it possible to secure a space between the glass 4 and the light-blocking wall 101. This makes it possible to suppress interference of the glass 4 with the light-blocking wall 101 upon mounting of the glass 4 from the upper side on the glass support surface 24 of the stiffener 7. As a result, it is possible to prevent pitting or the like of the glass 4.

### (Second Modification Example)

As illustrated in FIG. 19B, in a configuration of a second modification example, the light-blocking wall 101 has a shape in which the wall thickness is gradually decreased from the lower side to the upper side by forming the glass-side wall surface 102 as an inclined surface. That is, the light-blocking wall 101 has a wall thickness gradually decreased from the wall thickness D1 of the base end to the wall thickness D2 of the upper end by an inclined shape of the glass-side wall surface 102.

In an example illustrated in FIG. 19B, the glass-side wall surface 102 is inclined upward from the left side to the right side so as to cause the wall thickness D2 of the upper end of the light-blocking wall 101 to be a dimension of substantially a half of the wall thickness D1 of the base end. As in the present modification example, in a configuration in which the wall thickness of the light-blocking wall 101 is gradually decreased from the lower side to the upper side by the inclined shape of the glass-side wall surface 102, the gap 105 is gradually increased from the lower side to the upper side in accordance with a decrease in the wall thickness of the light-blocking wall 101.

According to the configuration of the second modification example also, as in the configuration of the first modification example, it is possible to suppress interference of the glass 4 with the light-blocking wall 101 upon mounting of the glass 4, thus making it possible to prevent pitting or the like of the glass 4.

### <10. Configuration Example of Solid-state Imaging Device According to Sixth Embodiment>

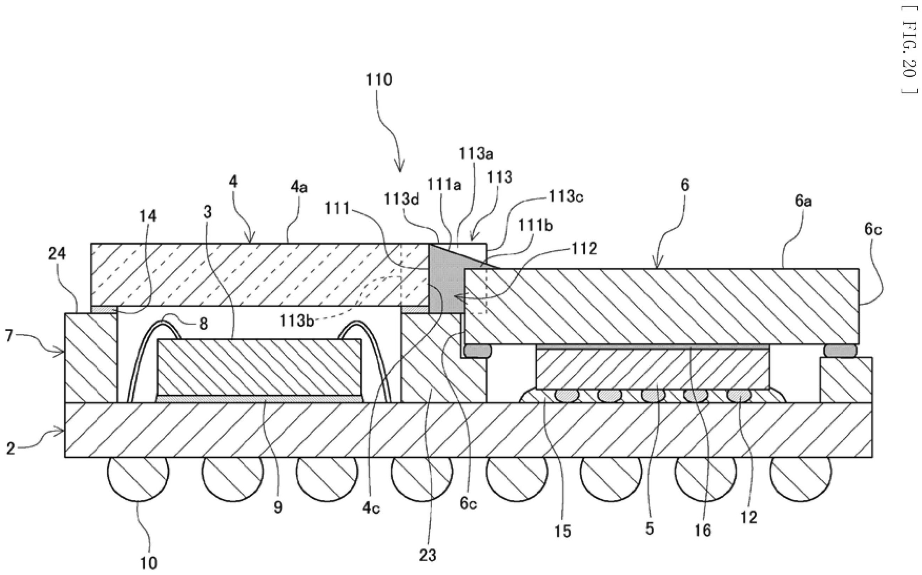

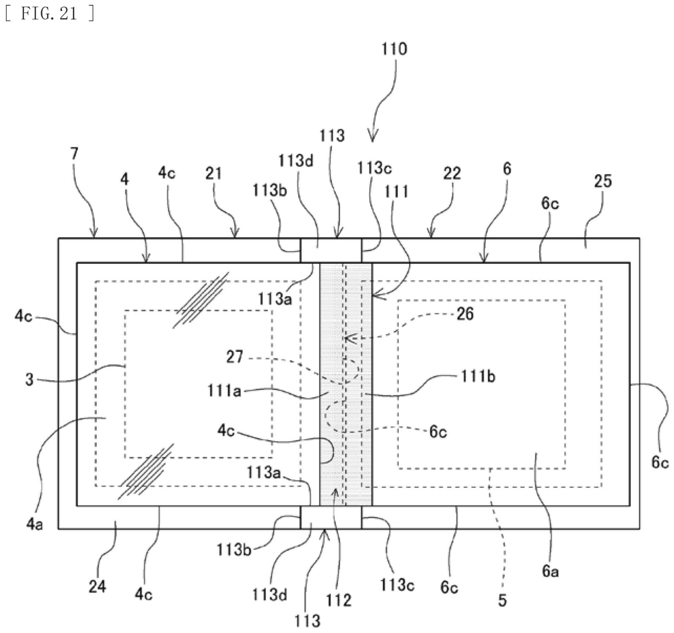

Description is given, with reference to FIGs. 20 and 21, of a configuration example of a solid-state imaging device 110 according to a sixth embodiment of the present technology.

The solid-state imaging device 110 according to the present embodiment is different from the fifth embodiment in the configuration of the light-blocking portion interposed between the glass 4 and the heat dissipation lid 6. The light-blocking portion according to the present embodiment is formed by using a resin with which a space between the glass 4 and the heat dissipation lid 6 is filled. That is, as illustrated in FIGs. 20 and 21, the light-blocking portion is provided as a resin-applied portion 111 formed by curing a resin material with which the space between the glass 4 and the heat dissipation lid 6 is filled.

In a configuration in which the heat dissipation lid 6 is disposed at a position lower than the top surface 4a of the glass 4, the resin-applied portion 111 includes a resin with which a groove-shaped space portion 112 between the side surface 4c on the right side of the glass 4 and the side surface 6c on the left side of the heat dissipation lid 6 on the intermediate side portion 23 of the stiffener 7 is filled. Accordingly, the resin-applied portion 111 is formed on the upper side of the intermediate side portion 23 of the stiffener 7 along the substrate short-side direction. The resin-applied portion 111 may be formed in an entire range between the glass 4 and the heat dissipation lid 6 in the substrate short-side direction, or may be formed in an intermediate portion excluding both end portions in the substrate short-side direction of the range between the glass 4 and the heat dissipation lid 6.

The space portion 112 filled with a resin material is a groove-shaped gap portion formed by the glass support surface 24 on the upper side of the intermediate side portion 23, the side surface 4c on the right side of the glass 4, and an portion, above the glass support surface 24, of the side surface 6c on the left side of the heat dissipation lid 6. The resin-applied portion 111 is formed in a state of covering the entire or substantially entire surfaces that form the space portion 112.

For example, the resin-applied portion 111 is provided to cover the entire side surface 4c on the right side of the glass 4 (see FIG. 20). The resin-applied portion 111 has an upper surface as an inclined surface 111a that is lowered from the left side to the right side by a difference in height between the top surface 4a of the glass 4 and the top surface 6a of the heat dissipation lid 6. In addition, in the resin-applied portion 111, a lid covering portion 111b that covers an edge portion on the left side of the top surface 6a of the heat dissipation lid 6 is formed by a state of filling the space portion 112 with the resin material, a difference in height between the top surface 4a of the glass 4 and the top surface 6a of the heat dissipation lid 6, viscosity of the resin material, and the like. The lid covering portion 111b is a portion including a resin material extending from the space portion 112 onto the top surface 6a of the heat dissipation lid 6.

The resin-applied portion 111 includes, for example, a resin material having a light-blocking property, such as a black resin material including a black pigment such as carbon black or titanium black. Examples of the material included in the resin-applied portion 111 include a thermosetting resin such as an acrylic-based resin or an epoxy-based resin, a thermoplastic resin such as polyamide imide or polypropylene, a photosensitive resin such as a UV curable resin that is an acrylic-based resin, and another known resin material.

The resin material that forms the resin-applied portion 111 is applied to the space portion 112 while being discharged from a nozzle of a dispenser by, for example, potting processing using the dispenser. The applied resin material is cured by heating, irradiation with UV light, or the like in accordance with properties of the resin material to form the resin-applied portion 111.

In addition, in the solid-state imaging device 110 according to the present embodiment, as illustrated in FIGs. 20 and 21, a blocking portion 113 for blocking the resin material applied to the space portion 112 to hold the resin material at a predetermined position is provided. The blocking portions 113 are provided at two positions to block both sides of the space portion 112 in the substrate short-side direction.

The blocking portions 113 are each a wall-shaped portion provided to protrude from the glass support surface 24 on the upper side of the intermediate side portion 23. The blocking portions 113 are provided on both sides in the substrate short-side direction of a portion opposed to the glass 4 and the heat dissipation lid 6 so as to cause inner wall surfaces 113a thereof to contact or substantially contact the side surface 4c of the glass 4 and the side surface 6c of the heat dissipation lid 6.

In the illustrated example, the blocking portion 113 is provided as a portion having a rectangular parallelepiped outer shape having a rectangular shape in side view and plan view. A left side surface 113b of the blocking portion 113 is positioned to the left of the side surface 4c on the right side of the glass 4, and a right side surface 113c of the blocking portion 113 is positioned to the right of the side surface 6c on the left side of the heat dissipation lid 6. In addition, a flat top surface 113d of the blocking portion 113 is positioned at substantially the same height as that of the top surface 4a of the glass 4. It is to be noted that the shape of the blocking portion 113 is not particularly limited.

The blocking portion 113 is formed as a portion of the stiffener 7. That is, the blocking portion 113 is provided as a portion formed by partially raising a predetermined portion on the glass support surface 24 of the intermediate side portion 23 of the stiffener 7. However, the blocking portion 113 may be a portion provided by fixing a member separate from the stiffener 7 to the glass support surface 24 or the like of the stiffener 7 by an adhesive or the like.

According to the solid-state imaging device 110 according to the present embodiment, as in the fifth embodiment, it is possible to block, by the resin-applied portion 111, the reflected light (see the arrow C2 in FIG. 18) from the top surface 6a of the heat dissipation lid 6 that causes flare while downsizing the device configuration. This makes it possible to reduce light that is to enter the glass 4 from the side surface 4c on the right side, thus making it possible to suppress the flare.

In addition, the blocking portions 113 are provided on both sides in the substrate short-side direction of the space portion 112 filled with the resin-applied portion 111, which makes it possible to suppress flowing of the resin material with which the space portion 112 is to be filled to outside the space portion 112 upon formation of the resin-applied portion 111. This makes it possible to efficiently form the resin-applied portion 111.

### <11. Modification Example of Solid-state Imaging Device According to Sixth Embodiment>

Description is given of a modification example of the solid-state imaging device 110 according to the sixth embodiment of the present technology.

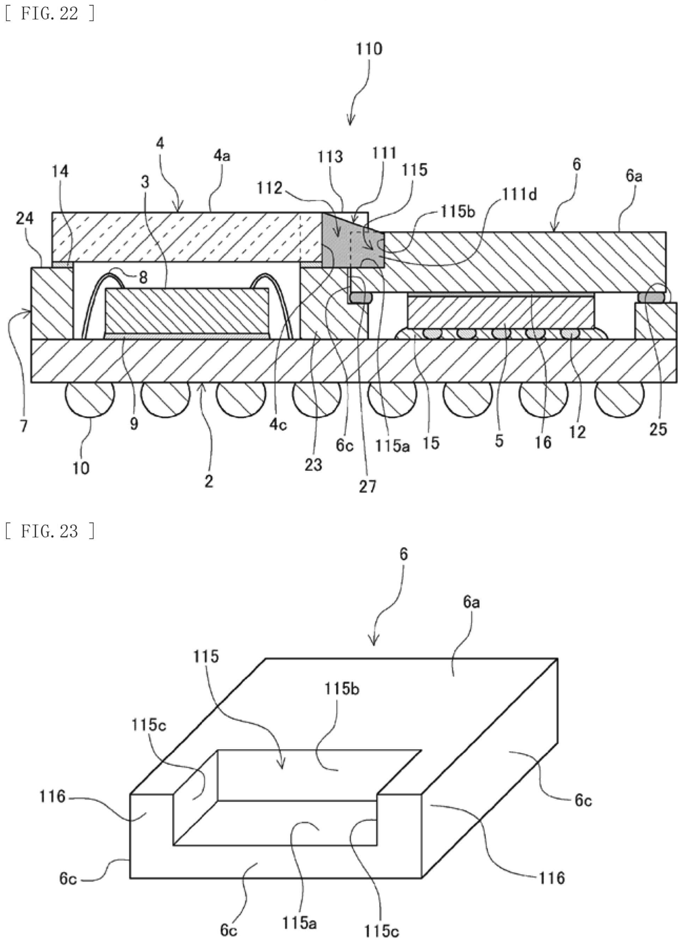

As illustrated in FIGs. 22 and 23, in a configuration of this modification example, the heat dissipation lid 6 has a recessed portion 115 for taking in the resin material that forms the resin-applied portion 111. The recessed portion 115 is a portion formed in a state in which a corner portion on the upper left side of the heat dissipation lid 6 is cut out, and is formed to form a space continuous with the space portion 112.

The recessed portion 115 is formed to form a rectangular space portion along the outer shape of the heat dissipation lid 6. In addition, the recessed portion 115 is formed in an intermediate portion excluding both end portions in the substrate short-side direction of an edge portion on the left side of the heat dissipation lid 6 (see FIG. 23). Accordingly, the recessed portion 115 has a horizontal bottom surface 115a, a first side surface 115b that is parallel to the side surface 6c on the left side, and second side surfaces 115c opposed to each other on both sides in the substrate short-side direction. The heat dissipation lid 6 has the recessed portion 115, and thereby has, on both sides in the substrate short-side direction, protruding wall portions 116 each having the second side surface 115c of the recessed portion 115 as an inner wall surface.

In the configuration of the present modification example, the resin material with which the space portion 112 is to be filled upon formation of the resin-applied portion 111 flows into the recessed portion 115 continuous with the space portion 112. Accordingly, the resin-applied portion 111 has, as a portion thereof, an in-recess resin portion 111d formed in the recessed portion 115.

According to the configuration of the present modification example, it is possible to expand, by the recessed portion 115, a space that takes in the resin material forming the resin-applied portion 111. As a result, it is possible to effectively suppress flowing of the resin material with which the space portion 112 is to be filled to outside the space portion 112 and the recessed portion 115. In addition, it is possible to have more space to which the resin material is to be supplied, which makes it easier to adjust an amount of the resin material for forming the resin-applied portion 111.

### <12. Configuration Example of Solid-state Imaging Device According to Seventh Embodiment>

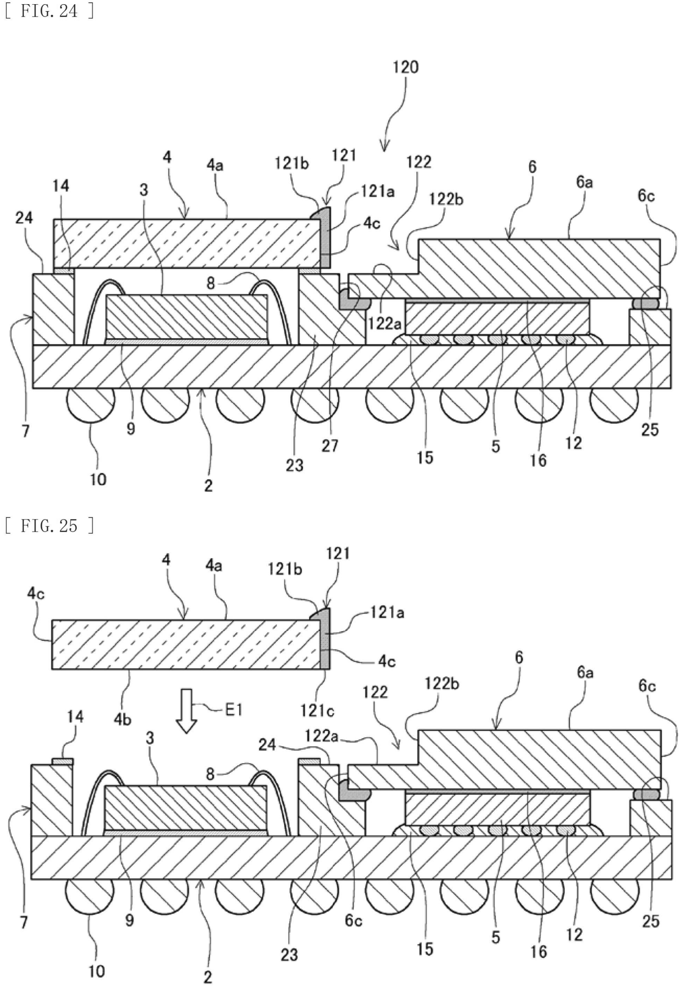

Description is given, with reference to FIGs. 24 and 25, of a solid-state imaging device 120 according to a seventh embodiment of the present technology.

The solid-state imaging device 120 according to the present embodiment is different from the fifth embodiment in the configuration of the light-blocking portion interposed between the glass 4 and the heat dissipation lid 6. The light-blocking portion according to the present embodiment is a covering resin portion 121 as a covering portion that covers at least the side surface 4c of the glass 4 on the side of the heat dissipation lid 6 (on the right side). That is, as illustrated in FIG. 24, the light-blocking portion is provided as the covering resin portion 121 that is a resin portion that entirely covers the side surface 4c on the right side of the glass 4.

The covering resin portion 121 is formed by applying a resin to the side surface 4c on the right side of the glass 4. The covering resin portion 121 may be formed in an entire range of the side surface 4c on the right side of the glass 4 in the substrate short-side direction, or may be formed in an intermediate portion excluding both end portions in the substrate short-side direction of the side surface 4c on the right side of the glass 4.

The covering resin portion 121 has a covering main body portion 121a that is a portion covering the side surface 4c on the right side of the glass 4, and a protruding portion 121b that is a portion protruding upward from the top surface 4a and covering an edge portion on the right side of the top surface 4a. The covering resin portion 121 is formed so as to cause a bottom surface 121c that is a lower surface of the covering main body portion 121a to be positioned on the same plane as the bottom surface 4b of the glass 4. Accordingly, the bottom surface 121c of the covering resin portion 121 is in a state of contacting or substantially contacting the glass support surface 24 on the upper side of the intermediate side portion 23 of the stiffener 7.

The covering resin portion 121 includes a resin material having a light-blocking property. The resin material that forms the covering resin portion 121 is similar to the resin material that forms the resin-applied portion 111 according to the sixth embodiment, and thus description thereof is omitted.

The covering resin portion 121 is formed on the glass 4 in a stage before mounting the glass 4 on the stiffener 7. That is, as illustrated in FIG. 25, the glass 4 is mounted on the glass support surface 24 of the stiffener 7 in a state in which the covering resin portion 121 has been formed on the glass 4 in advance (see an arrow E1).

As illustrated in FIGs. 24 and 25, in a configuration in which the heat dissipation lid 6 is disposed close to the glass 4, when the glass 4 provided with the covering resin portion 121 on the side surface 4c on the side of the heat dissipation lid 6 is mounted on the stiffener 7, in order to prevent the covering resin portion 121 from interfering with the heat dissipation lid 6, a recessed portion 122 may be provided in the heat dissipation lid 6.

The recessed portion 122 is a portion formed in a state in which a corner portion on the upper left side of the heat dissipation lid 6 is cut out to expand a space between the glass 4 and the heat dissipation lid 6 in a portion above the glass support surface 24. The recessed portion 122 is formed in an edge portion on the left side of the heat dissipation lid 6 to include at least a range where the covering resin portion 121 is formed in the substrate short-side direction. Although a shape of the recessed portion 122 is not particularly limited, in the illustrated example, the recessed portion 122 is formed as a right-angled notch portion having a bottom surface 122a and a side surface 122b.

According to the solid-state imaging device 120 according to the present embodiment, as in the fifth embodiment, it is possible to block, by the covering resin portion 121, the reflected light (see the arrow C2 in FIG. 18) from the top surface 6a of the heat dissipation lid 6 that causes flare while downsizing the device configuration. This makes it possible to reduce light that is to enter the glass 4 from the side surface 4c on the right side, thus making it possible to suppress flare.

In addition, the heat dissipation lid 6 has the recessed portion 122, which makes it possible to prevent the covering resin portion 121 from contacting the heat dissipation lid 6 when mounting the glass 4 provided with the covering resin portion 121 on the side surface 4c on the side of the heat dissipation lid 6. As a result, it is possible to prevent the covering resin portion 121 from contacting the heat dissipation lid 6 and being peeled off, for example. As a result, it is possible to reliably achieve a light-blocking effect by the covering resin portion 121.

### <13. Modification Example of Solid-state Imaging Device According to Seventh Embodiment>

Description is given of a modification example of the solid-state imaging device 120 according to the seventh embodiment of the present technology.

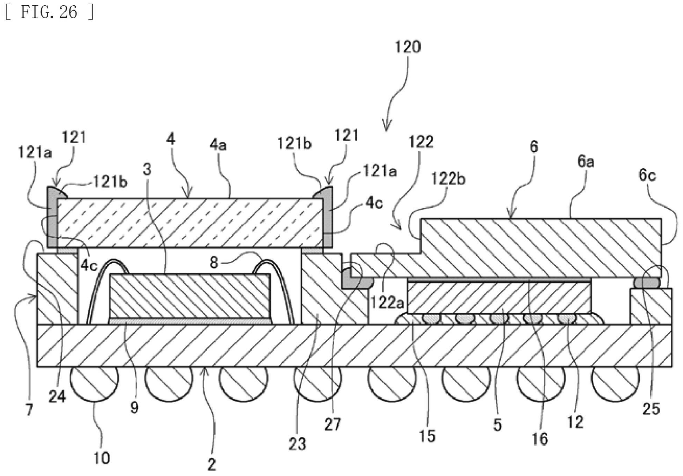

As illustrated in FIG. 26, in a configuration of this modification example, the covering resin portions 121 are provided on the side surfaces 4c of the glass 4 on both the right and left sides. The right and left covering resin portions 121 are formed to have shapes symmetrical to each other in the right-left direction.

According to the configuration of the present modification example, the covering resin portion 121 also covers the side surface 4c of the glass 4 on a side opposite to the side of the heat dissipation lid 6, which makes it possible to reduce light that is to enter the glass 4 from the side surfaces 4c on the right and left sides, thus making it possible to effectively suppress flare. It is to be noted that the covering resin portion 121 may be provided for three sides of the glass 4 having a rectangular plate shape, or may be provided to cover the four sides, that is, the entire four side surfaces 4c.

### <14. Method of Manufacturing Solid-state Imaging Device According to Seventh Embodiment>

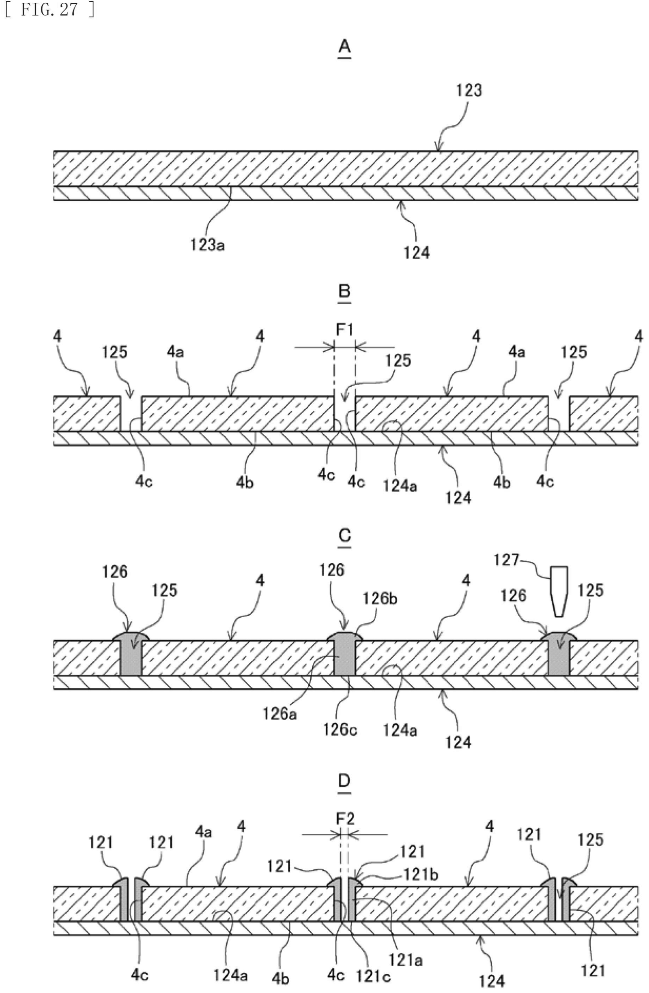

Description is given, with reference to FIG. 27, of an example of a method of manufacturing the solid-state imaging device 120 according to the seventh embodiment of the present technology. Here, description is given of an example of a method of providing the covering resin portion 121 on the glass 4. This example is an example of a method of providing the covering resin portions 121 on the side surfaces 4c of the glass 4 on both the right and left sides as in the modification example illustrated in FIG. 26.

First, as illustrated in FIG. 27A, a dicing tape 124 is attached to one plate surface 123a of a glass plate 123 that is a material of the glass 4.

Next, as illustrated in FIG. 27B, dicing using a blade, a laser, or the like is performed on the glass plate 123 from a side opposite to a side of the dicing tape 124 to thereby singulate the glass plate 123 into a plurality of glasses 4. Thus, a state is obtained in which the plurality of glasses 4 is disposed on an adhesive surface 124a of the dicing tape 124 with gaps 125 having a predetermined dimension interposed therebetween. The dicing is performed so as to cause a width dimension F1 of the gap 125 to be twice or more as large as a thickness of the covering main body portion 121a (see FIG. 26) of the covering resin portion 121. It is to be noted that the state illustrated in FIG. 27B is obtained also by arranging the glasses 4, into which the glass plate 123 has been singulated in advance, on the adhesive surface 124a of the dicing tape 124, for example.

Next, as illustrated in FIG. 27C, a resin material 126 that is to be the covering resin portion 121 is applied to the gap 125 between the adjacent glasses 4. The resin material 126 is applied to fill the gap 125 therewith and slightly overflow from the gap 125 while being discharged from a nozzle 127 of a dispenser, for example. Thereafter, for example, a process of curing the resin material 126 such as a heating process (curing) or a UV light irradiation process is performed in accordance with properties of the resin material 126.

The resin material 126 is cured to thereby form, as resin portions in close contact with the glass 4, an in-gap resin portion 126a that is a portion in the gap 125, and an overflow portion 126b that is a portion overflowing from the gap 125 on the side (the side of the top surface 4a) opposite to the side of the dicing tape 124. A bottom surface 126c of the in-gap resin portion 126a serves as a surface contacting the dicing tape 124. The overflow portion 126b has an upwardly protruding and swollen shape in side cross-sectional view, and is formed to cover an edge portion of the top surface 4a of the glass 4 on a side of the gap 125.

Next, as illustrated in FIG. 27D, singulation is performed by dicing using a blade, a laser, or the like. In the dicing, a dicing line is positioned in a middle of the gap 125 in a width direction (the right-left direction in the drawing). A middle portion of the resin material 126 in the width direction of the gap 125 is cut by dicing to form, as right and left portions into which the resin material 126 is separated, the covering resin portions 121 on the respective side surfaces 4c of the glasses 4. In consideration of a width dimension F2 of a cutout portion of the resin material 126 by dicing here, the width dimension F1 (see FIG. 27B) of the gap 125 is set to form the covering resin portion 121 having a predetermined thickness.

Separated portions of the in-gap resin portion 126a and the overflow portion 126b of the resin material 126 respectively become the covering main body portion 121a and the protruding portion 121b of the covering resin portion 121. In addition, portions on both sides in the width direction of the bottom surface 126c of the resin material 126 each serve as the bottom surface 121c of the covering resin portion 121.

Thereafter, the glass 4 on which the covering resin portion 121 has been formed is picked up from, for example, the dicing tape 124, and fixed to the glass support surface 24 of the stiffener 7 by the adhesive 14 (see the arrow El in FIG. 25).

According to the method of forming the covering resin portion 121 as described above, it is possible to form the covering resin portions 121 simultaneously on the plurality of glasses 4. This makes it possible to efficiently manufacture the glass 4 provided with the covering resin portion 121.

In the process of singulating a glass on the dicing tape 124 (see FIG. 27B), a method of forming a groove portion at a position where the gap 125 is to be formed may be used without completely separating (singulating) the glass plate into a plurality of glasses 4. That is, a method may be used in which dicing of the glass plate is performed halfway in a plate thickness direction to form a recessed groove portion between portions that are to be the glasses 4. In the case of using such a method, the covering resin portion 121 formed by singulating after the resin material is applied into the groove portion and cured is formed in a range up to a midpoint in the plate thickness direction of the glass 4 in accordance with a depth of a groove on the lower side. In a configuration in which light does not enter the glass 4 from a portion on the lower side of the side surface 4c, such a method may be used as a method of forming the covering resin portion 121.

### <15. Configuration Example of Solid-state Imaging Device According to Eighth Embodiment>

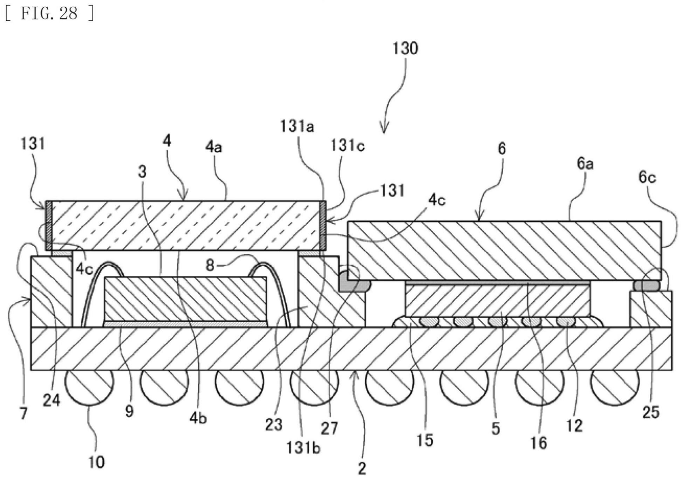

Description is given, with reference to FIG. 28, of a solid-state imaging device 130 according to an eighth embodiment of the present technology.

The solid-state imaging device 130 according to the present embodiment is different from the fifth embodiment in the configuration of the light-blocking portion interposed between the glass 4 and the heat dissipation lid 6. The light-blocking portion according to the present embodiment is a light-blocking film 131 as a covering portion that covers at least the side surface 4c of the glass 4 on the side of the heat dissipation lid 6 (on the right side). In the present embodiment, as illustrated in FIG. 28, the light-blocking portion is provided as the light-blocking film 131 that entirely covers each of the side surfaces 4c of the glass 4 on both the right and left sides.

The light-blocking film 131 is a thin film including a resin material or a metal material formed on the side surface 4c of the glass 4. The light-blocking film 131 may be formed in an entire range of the side surface 4c on the right side of the glass 4 in the substrate short-side direction, or may be formed in an intermediate portion excluding both end portions in the substrate short-side direction of the side surface 4c on the right side of the glass 4.

The light-blocking film 131 has a predetermined film thickness, and has the same or substantially the same dimension as that of the plate thickness of the glass 4 in the up-down direction. That is, the light-blocking film 131 has a top surface 131a and a bottom surface 131b that are respectively positioned on the same planes as the top surface 4a and the bottom surface 4b of the glass 4, and an outer surface 131c that is parallel to the side surface 4c of the glass 4. The bottom surface 131b of the light-blocking film 131 is in a state of contacting or substantially contacting the glass support surface 24 on the upper side of the intermediate side portion 23 of the stiffener 7.

The light-blocking film 131 includes a material having a light-blocking property. In a case where the material that forms the light-blocking film 131 is a resin material, for example, the same material as the resin material that forms the resin-applied portion 111 according to the sixth embodiment is used.

The light-blocking film 131 is formed on the glass 4 in a stage before mounting the glass 4 on the stiffener 7. That is, as in a configuration in which the covering resin portion 121 according to the seventh embodiment is provided on the glass 4, the glass 4 is mounted on the glass support surface 24 of the stiffener 7 in a state in which the light-blocking film 131 has been formed on the glass 4 in advance (see the arrow E1 in FIG. 25).

According to the solid-state imaging device 130 according to the present embodiment, as in the fifth embodiment, it is possible to block, by the light-blocking film 131, the reflected light (see the arrow C2 in FIG. 18) from the top surface 6a of the heat dissipation lid 6 that causes flare while downsizing the device configuration. This makes it possible to reduce light that is to enter the glass 4 from the side surface 4c, thus making it possible to suppress flare. It is to be noted that the light-blocking film 131 may be provided only on the side surface 4c, on the side of the heat dissipation lid 6, of the glass 4 having a rectangular plate shape, or may be provided on three sides or four sides of the glass 4 having a rectangular plate shape.

### <16. Method of Manufacturing Solid-state Imaging Device According to Eighth Embodiment>

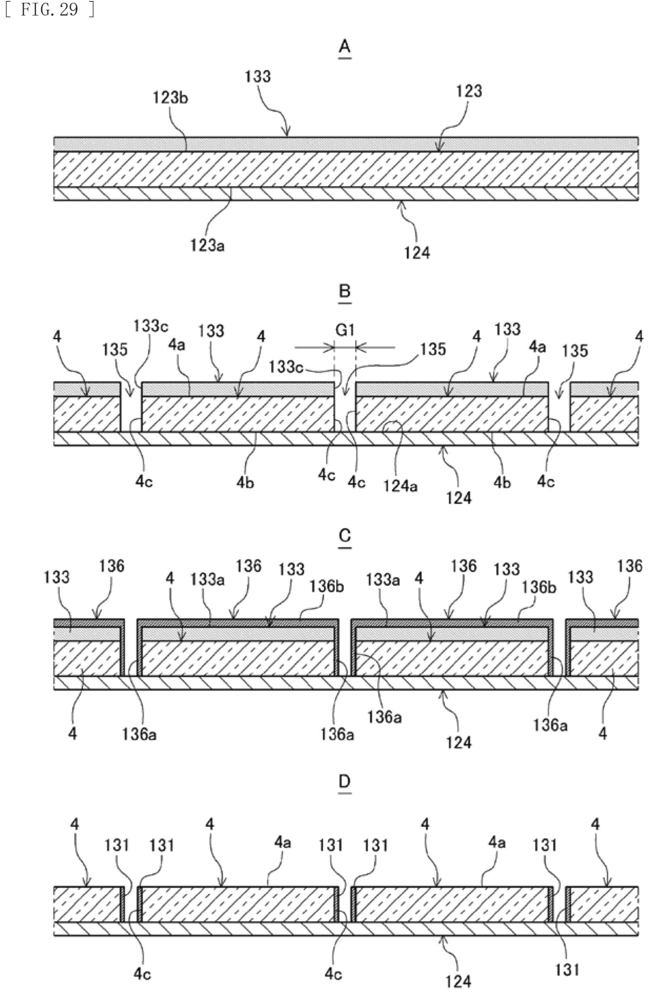

Description is given, with reference to FIG. 29, of an example of a method of manufacturing the solid-state imaging device 130 according to the eighth embodiment of the present technology. Here, description is given of an example of a method of providing the light-blocking film 131 on the glass 4.

First, as illustrated in FIG. 29A, a resist mask 133 is formed on another plate surface 123b of the glass plate 123 having the one plate surface 123a to which the dicing tape 124 is attached.

Next, as illustrated in FIG. 29B, dicing using a blade, a laser, or the like is performed on the glass plate 123 from a side of the resist mask 133 to thereby singulate the glass plate 123 together with the resist mask 133 into a plurality of glasses 4. Thus, a state is obtained in which the plurality of glasses 4 each having the resist mask 133 on the side of the top surface 4a (hereinafter referred to as "masked glasses 4") is disposed on the adhesive surface 124a of the dicing tape 124 with gaps 135 having a predetermined dimension interposed therebetween. The dicing is performed so as to cause a width dimension G1 of the gap 135 to be twice or more as large as a film thickness of the light-blocking film 131.

Next, as illustrated in FIG. 29C, a process of forming a light-blocking film 136 including a portion that is to be the light-blocking film 131 on the plurality of masked glasses 4 on the dicing tape 124 is performed. The light-blocking film 136 is formed by, for example, film formation by spraying and coating of a resin material, a paint, or the like, or a CVD (Chemical Vapor Deposition) method using a CVD device.

The light-blocking film 136 is formed on each of the masked glasses 4 to cover side surfaces that are surfaces opposed to each other with the gap 135 interposed therebetween, and a top surface 133a of the resist mask 133. That is, the light-blocking film 136 includes side surface covering portions 136a that cover the side surfaces, and a top surface covering portion 136b that covers the top surface 133a of the resist mask 133 as portions that cover the masked glass 4. It is to be noted that the side surface of the masked glass 4 is a surface in which the side surface 4c of the glass 4 and the side surface 133c of the resist mask 133 are continuous with each other.

Next, as illustrated in FIG. 29D, a process of removing a portion of the light-blocking film 136 and the resist mask 133 to expose the top surface 4a of the glass 4 is performed. The top surface covering portion 136b and an upper portion, which covers the side surface 133c of the resist mask 133, of the side surface covering portion 136a of the light-blocking film 136 are removed. The portion of the light-blocking film 136 and the resist mask 133 are removed by a known method such as a dry process using plasma or the like, a wet process using an organic solvent-based chemical solution, or a method using a peeling agent. A portion of the light-blocking film 136 that remains after the removing process, that is, a portion, which covers the side surface 4c of the glass 4, of the side surface covering portion 136a becomes the light-blocking film 131.

Thereafter, the glass 4 on which the light-blocking film 131 is formed is picked up from, for example, the dicing tape 124, and fixed to the glass support surface 24 of the stiffener 7 by the adhesive 14 (see the arrow E1 in FIG. 25).

According to the method of forming the light-blocking film 131 as described above, it is possible to form the light-blocking films 131 simultaneously on the plurality of glasses 4. This makes it possible to efficiently manufacture the glass 4 provided with the light-blocking film 131. It is to be noted that, in the process of singulating a glass on the dicing tape 124 (see FIG. 29B), using a method of forming a recessed groove portion at a position where the gap 135 is to be formed to thereby partially provide the light-blocking film 131 on the side surface 4c of the glass 4 in the plate thickness direction is the same as in a case of the method of forming the covering resin portion 121 according to the seventh embodiment.

### <17. Modification Example of Solid-state Imaging Device According to Eighth Embodiment>

Description is given of a modification example of the solid-state imaging device 130 according to the eighth embodiment of the present technology.

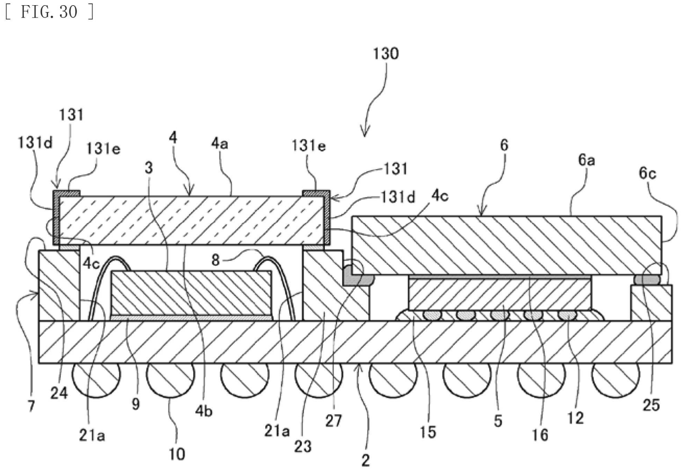

As illustrated in FIG. 30, in a configuration of this modification example, the light-blocking film 131 includes a portion that covers an edge portion of the top surface 4a of the glass 4. That is, in this modification example, the light-blocking film 131 includes a side surface film portion 131d that is a portion covering the side surface 4c of the glass 4, and a front surface film portion 131e that is a portion covering the edge portion of the top surface 4a of the glass 4. The side surface film portion 131d and the front surface film portion 131e are continuous with each other along a shape of a corner portion of the glass 4, and are formed to have a substantially inverted "L" shape in cross-sectional view as illustrated in FIG. 30.

The front surface film portion 131e is formed, for example, in a region of the edge portion of the top surface 4a of the glass 4 not to overlap the pixel region of the image sensor 3 in plan view. In an example illustrated in FIG. 30, left and right inner edge ends of the front surface film portions 131e are positioned at substantially the same positions as inner surfaces 21a of right and left side portions of the first support frame portions 21 of the stiffener 7 in the right-left direction. The right and left light-blocking films 131 are formed to have shapes symmetrical to each other in the right-left direction.

According to the configuration of the present modification example, the light-blocking film 131 also covers the edge portion of the top surface 4a of the glass 4 in addition to the side surface 4, which makes it possible to reduce light that is to enter the glass 4 from the edge portion of the top surface 4a, thus making it possible to effectively suppress flare.

### <18. Method of Manufacturing Modification Example of Solid-state Imaging Device According to Eighth Embodiment>

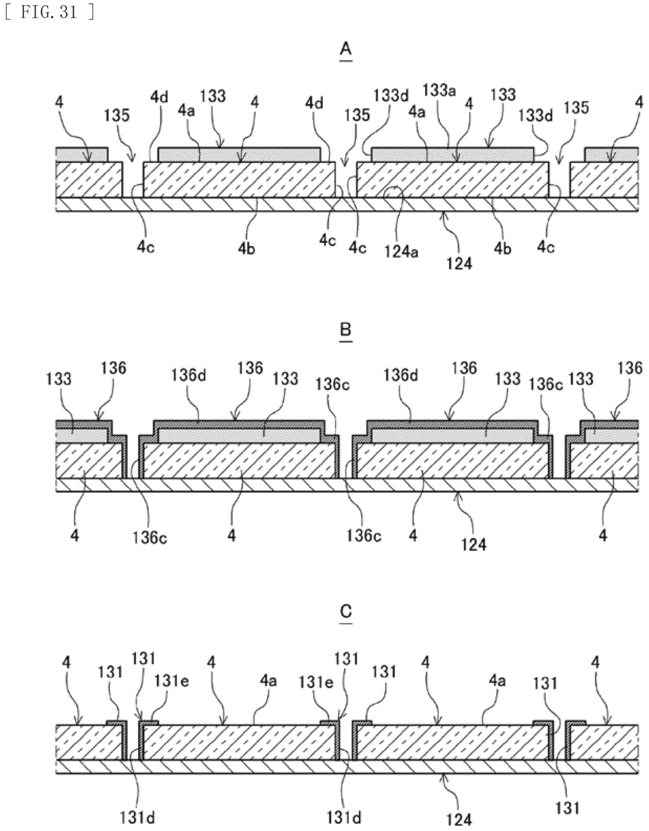

Description is given, with reference to FIG. 31, of a method of manufacturing the modification example of the solid-state imaging device 130 according to the eighth embodiment of the present technology. Here, description is given of an example of a method of providing the light-blocking film 131 on the glass 4.

First, as in the method of forming the light-blocking film 131 described with reference to FIG. 29, the resist mask 133 is formed on the plate surface 123b of the glass plate 123 to which the dicing tape 124 is attached (see FIG. 29A), and thereafter, the glass plate 123 is singulated together with the resist mask 133 into a plurality of glasses 4 by dicing (see FIG. 29B).

Next, as illustrated in FIG. 31A, a process of partially removing the resist mask 133 of the masked glass 4 to expose edge portions 4d on both the right and left sides of the top surface 4a of the glass 4 is performed. The resist mask 133 is partially removed by, for example, a method using plasma, a chemical solution, or the like.

Next, as illustrated in FIG. 31B, a process of forming the light-blocking film 136 on the plurality of masked glasses 4 on the dicing tape 124 is performed by spraying and coating of a predetermined material or a CVD method. Here, the masked glass 4 has edge portions 4d that are not covered by the resist mask 133 on the top surface 4a.

The light-blocking film 136 is formed on each of the masked glasses 4 to cover the side surfaces 4c and the edge portions 4d of the glass 4 and the side surfaces 133d and the top surface 133a of the resist mask 133. That is, the light-blocking film 136 includes a glass covering portion 136c that covers the side surfaces 4c and the edge portions 4d of the glass 4 and a resist covering portion 136d that covers the side surfaces 133d and the top surface 133a of the resist mask 133 as portions that cover the masked glass 4.

Next, as illustrated in FIG. 31C, a process of removing a portion of the light-blocking film 136 and the resist mask 133 to expose the top surface 4a of the glass 4 is performed. The resist covering portion 136d of the light-blocking film 136 is removed. A portion of the light-blocking film 136 that remains after the removing process, that is, a portion that has been the glass covering portion 136c of the light-blocking film 136 becomes the light-blocking film 131. Thus, the glass 4 is obtained on which the light-blocking film 131 including the side surface film portion 131d and the front surface film portion 131e is formed.

According to the method of forming the light-blocking film 131 as described above, it is possible to form the light-blocking films 131 simultaneously on the plurality of glasses 4. This makes it possible to efficiently manufacture the glass 4 provided with the light-blocking film 131 including the side surface film portion 131d and the front surface film portion 131e.

### <19. Configuration Example of Imaging Device According to Ninth Embodiment>

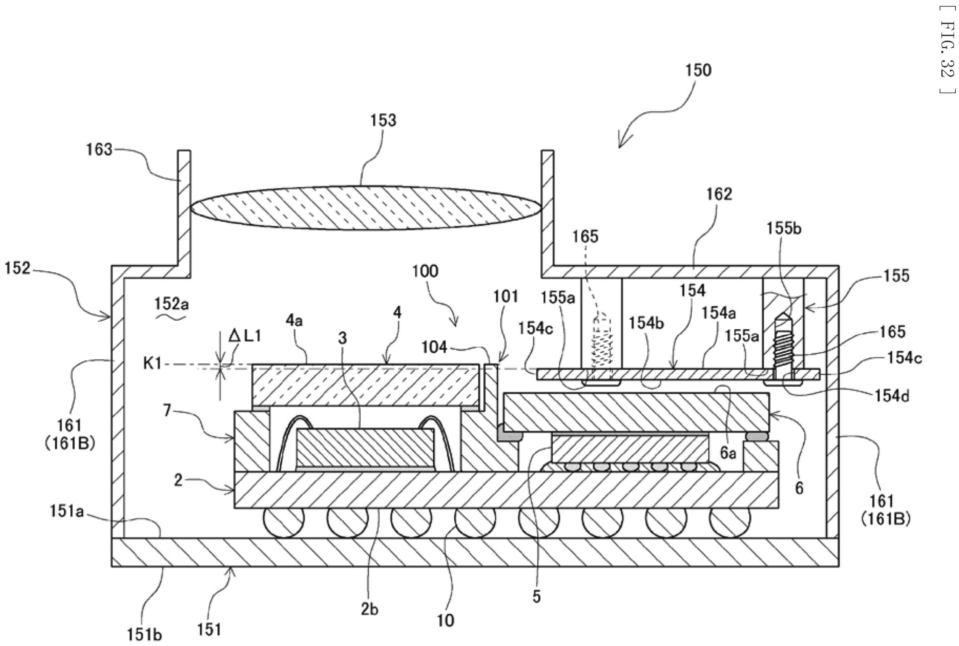

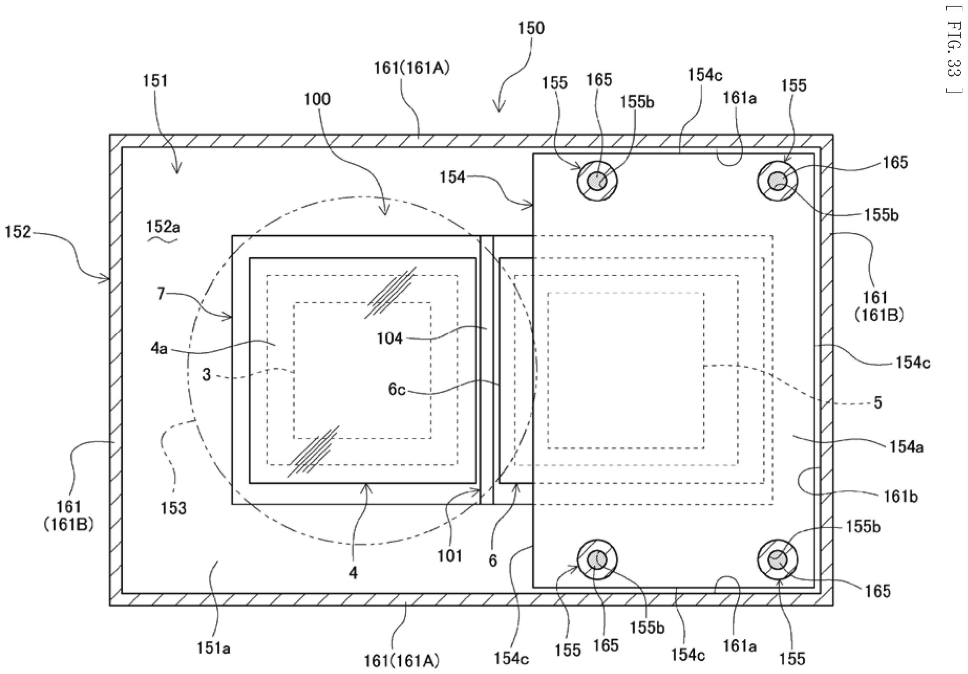

Description is given, with reference to FIGs. 32 and 33, of a configuration example of an imaging device 150 according to a ninth embodiment of the present technology. The imaging device 150 is an example of a semiconductor device according to the present technology.

The imaging device 150 according to the present embodiment is a camera module having a configuration in which the solid-state imaging device as a multi-chip package according to any of the embodiments described above is included and the solid-state imaging device is mounted on a mounting substrate and is housed in a lens housing. In an example illustrated in FIGs. 32 and 33, the imaging device 150 includes the solid-state imaging device 100 according to the fifth embodiment as a multi-chip package.

As illustrated in FIGs. 32 and 33, the imaging device 150 includes a set substrate 151 as a mounting substrate on which the substrate 2 of the solid-state imaging device 100 is mounted, and a housing 152 for holding the lens 153 provided for the image sensor 3. Furthermore, the imaging device 150 includes a housing plate 154 as a light-blocking member inside the housing 152.

The set substrate 151 is a circuit substrate including an organic material such as plastic, ceramic, or the like. The set substrate 151 has, for example, a structure in which a copper wiring is installed on a glass epoxy. The set substrate 151 has a front surface 151a and a back surface 151b, and the solid-state imaging device 100 is mounted on the set substrate 151 on a side of the front surface 151a. The solid-state imaging device 100 is reflow-mounted on the set substrate 151 by a plurality of solder balls 10 provided on the side of the back surface 2b of the substrate 2.

The housing 152 houses the solid-state imaging device 100 mounted on the set substrate 151, and forms a housing space 152a that is a hollow portion above the set substrate 151 with the set substrate 151 as a bottom portion. The housing 152 includes, for example, a material having a light-blocking property such as a black resin material, and functions as a light-blocking cover for the solid-state imaging device 100.

The housing 152 includes four sidewall portions 161 (161A and 161B), a top surface portion 162, and a lens support portion 163 that supports one or a plurality of lenses 153. The housing 152 is fixed to the set substrate 151 by a fixing tool such as an adhesive or a bolt. In the illustrated example, the housing 152 is fixed to the set substrate 151 in a state in which the four sidewall portions 161 are placed on an edge portion of the front surface 151a of the set substrate along an outer shape of the set substrate 151 in plan view.

The sidewall portion 161 is a wall surface portion perpendicular to the front surface 151a of the set substrate 151. The top surface portion 162 is, for example, a surface portion formed in parallel with the set substrate 151, and forms a right-angled corner portion with each of the sidewall portions 161.

The lens support portion 163 is a frame portion for a lens mount configured in a tubular shape, and is provided at a position above the image sensor 3 of the solid-state imaging device 100. The lens support portion 163 is configured to support the one or plurality of lenses 153 in a direction in which a lens optical axis is perpendicular to the light-receiving surface of the image sensor 3. Light from a subject is condensed by the one or plurality of lenses 153, and the condensed light is received by the light-receiving region of the image sensor 3.

The housing plate 154 is provided in the housing 152, and covers at least a part of the heat dissipation lid 6 from the upper side opposite to the side of the substrate 2. In the present embodiment, the housing plate 154 is a rectangular plate-shaped member having a predetermined thickness. The housing plate 154 has a top surface 154a, a bottom surface 154b, and four side end surfaces 154c. A plate thickness dimension of the housing plate 154 is, for example, about 1/2 to 1/4 of a plate thickness dimension of the heat dissipation lid 6.

The housing plate 154 includes a material having a light-blocking property, for example, a resin material such as a black resin material or a metal material such as copper. The material of the housing plate 154 may be the same material as the material of the housing 152 or may be different from the material of the housing 152.

The housing plate 154 is provided to cover the entire or substantially entire heat dissipation lid 6 in plan view. In the illustrated example, the housing plate 154 is provided so as to cause the side end surface 154c on the left side to be positioned close to the side surface 6c on the left side of the heat dissipation lid 6 and cover a portion excluding an edge portion on the left side of the heat dissipation lid 6 in plan view (see FIG. 33). That is, in plan view, only the edge portion on the left side of the heat dissipation lid 6 is in a state of being exposed from the housing plate 154, and another portion of the heat dissipation lid 6 is covered with the housing plate 154.

The side end surfaces 154c on both sides in the substrate short-side direction (the up-down direction in FIG. 33) are provided close to inner wall surfaces 161a of the sidewall portions 161A each opposed to a corresponding one of the side end surfaces 154c to provide the housing plate 154 in a substantially entire range between both the sidewall portions 161A. In addition, in the housing plate 154, the side end surface 154c on the right side is provided close to the inner wall surface 161b of the sidewall portion 161B on the right side. That is, the housing plate 154 is provided to entirely cover a portion on the right side in the housing space 152a surrounded by the four sidewall portions 161 in plan view.

The housing plate 154 is provided at a position lower than the top surface 4a of the glass 4 in the up-down direction. In addition, in a configuration in which the stiffener 7 includes the light-blocking wall 101 between the glass 4 and the heat dissipation lid 6, the housing plate 154 is provided at a position lower than the top surface 104 of the light-blocking wall 101. In a case where the top surface 104 of the light-blocking wall 101 is positioned at the same height as that of the top surface 4a of the glass 4 and these surfaces are positioned on a same virtual plane K1, the housing plate 154 is provided so as to cause the top surface 154a thereof to be positioned at a height lower than the virtual plane K1 by an amount ΔL1. In addition, the housing plate 154 is provided at a predetermined distance from the top surface 6a of the heat dissipation lid 6.

The housing plate 154 is provided in a state of being fixed to the housing 152 at a plurality of points by screws 165. The housing 152 includes a plurality of boss portions 155 as portions to which the housing plate 154 is to be fixed by the screws 165. In the present embodiment, the boss portions 155 are provided at four points corresponding to portions close to four corners of the housing plate 154.

The boss portion 155 is, for example, a cylindrical portion, and is formed to protrude downward from a portion, positioned above the housing plate 154, of the top surface portion 162 of the housing 152. The boss portion 155 has a horizontal lower end surface 155a, and a screw hole 155b into which the screw 165 is to be inserted is opened facing the lower end surface 155a. Meanwhile, a circular screw hole 154d through which the screw 165 penetrates is formed close to each of the four corners of the housing plate 154.

The housing plate 154 is fastened and fixed to the housing 152 at four points by the screws 165 that penetrate through the housing plate 154 by the screw holes 154d and are inserted into the screw holes 155b in a state in which the top surface 154a contacts the lower end surfaces 155a of the boss portions 155. It is to be noted that an attaching structure of the housing plate 154 on the housing 152 is not particularly limited.

According to the imaging device 150 according to the present embodiment, in a configuration of the camera module in which the solid-state imaging device 100 is housed in the housing 152, the heat dissipation lid 6 is covered from above by the housing plate 154, which makes it possible to reduce entry of light into the top surface 6a of the heat dissipation lid 6. Accordingly, in a configuration in which the top surface 6a of the heat dissipation lid 6 is made lower than the top surface 4a of the glass 4, it is possible to reduce the reflected light from the top surface 6a of the heat dissipation lid 6 that causes flare, thus making it possible to suppress flare.

In addition, the housing plate 154 is provided at a position lower than the top surface 4a of the glass 4. According to such a configuration, it is possible to suppress entry of reflected light from, for example, the side end surface 154c on the left side of the housing plate 154 into the image sensor 3 through the glass 4, thus making it possible to suppress occurrence of flare. It is to be noted that in a case where the housing plate 154 is disposed at a position higher than the top surface 4a of the glass 4, a length of the housing plate 154 in the substrate long-side direction is shortened to separate the side end surface 154c on the left side and the glass 4 from each other, which makes it possible to prevent the reflected light from the housing plate 154 from causing flare. Also in a case where the length of the housing plate 154 is shortened, the housing plate 154 is preferably provided to cover at least a half or more of the heat dissipation lid 6 in the substrate long-side direction from above.

In addition, in a configuration in which the light-blocking wall 101 is provided between the glass 4 and the heat dissipation lid 6 as in the solid-state imaging device 100, the housing plate 154 is provided at a position lower than the top surface 104 of the light-blocking wall 101. According to such a configuration, it is possible to effectively prevent reflected light from the housing plate 154 from entering the glass 4 by the light-blocking wall 101, as compared with a case where the housing plate 154 is positioned at a position higher than the light-blocking wall 101. This makes it possible to suppress flare.

In addition, in the present embodiment, the housing plate 154 is provided as a member separate from the housing 152, and is fixed to the housing 152 by fixing portions using the screws 165. According to such a configuration, for example, the housing plate 154 includes a material having a higher thermal conductivity than that of the material of the housing 152, which makes it possible to improve heat dissipation characteristics of the imaging device 150. Specifically, for example, in a case where the housing 152 includes a resin material, it is possible to use, as the housing plate 154, a metal-made member including copper or the like having a relatively high thermal conductivity. In addition, according to a fixing structure of the housing plate 154 by the screws 165, the housing plate 154 is easily attachable to and detachable from the housing 152, which makes it possible to easily replace the housing plate 154.

In the housing plate 154 according to the present embodiment, a surface of the housing plate 154 may be subjected to a surface treatment to be less reflective to light. As the surface treatment, for example, the surface of the metal-made housing plate 154 is subjected to a low reflection treatment such as a black treatment or a matte treatment. According to a configuration in which lower reflection by the surface of the housing plate 154 is achieved as described above, it is possible to reduce reflected light from the surface of the housing plate 154 while using a metal-made member having a relatively high heat dissipation property as the housing plate 154. This makes it possible to suppress flare.

### <20. Modification Example of Imaging Device According to Ninth Embodiment>

Description is given of a modification example of the imaging device 150 according to the ninth embodiment of the present technology.

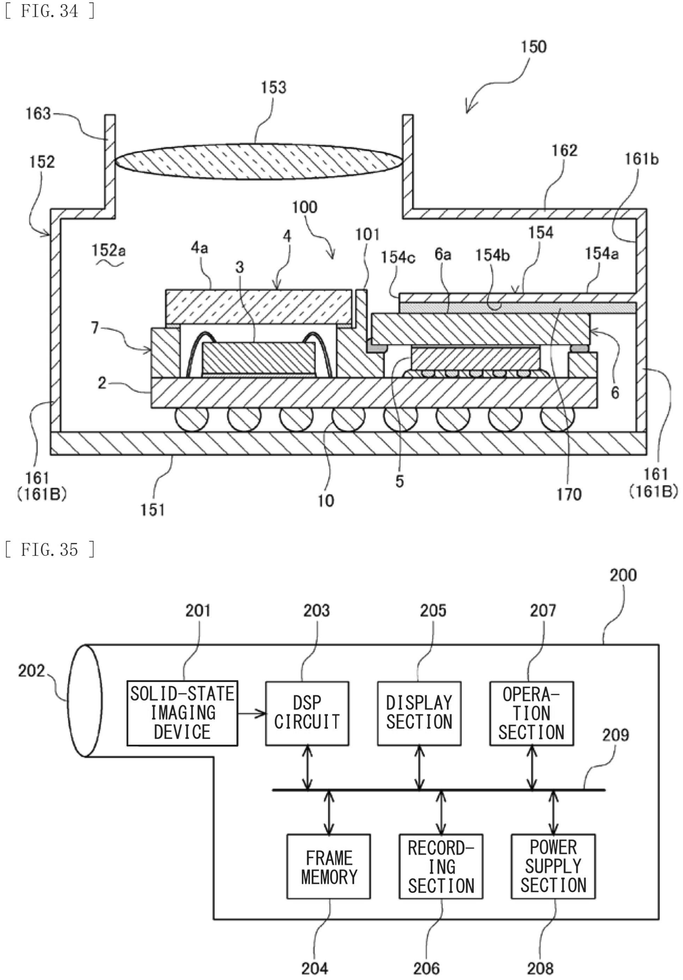

As illustrated in FIG. 34, in a configuration of this modification example, the housing plate 154 is provided as a portion integral with the housing 152. The housing plate 154 is provided as an extending portion from the sidewall portion 161 of the housing 152. In the illustrated example, the housing plate 154 is provided as a portion horizontally extending from the inner wall surface 161b of the sidewall portion 161B on the right side of the housing 152.

It is to be noted that the housing plate 154 may be provided as a portion coupled to both or one of the inner wall surfaces 161a of the sidewall portions 161A (see FIG. 33) on both sides in the substrate short-side direction. In addition, the housing plate 154 may be provided as a portion coupled to only one or both of the sidewall portions 161A on both sides in the substrate short-side direction without being coupled to the sidewall portion 161B on the right side. Furthermore, the housing plate 154 may be a portion provided on the top surface portion 162 of the housing 152 through a predetermined support portion.

In addition, in the present embodiment, the housing plate 154 is provided with a heat dissipation portion 170 including a material having a higher thermal conductivity than that of the material that forms the housing plate 154. The heat dissipation portion 170 is provided on a side of the bottom surface 154b of the housing plate 154. The heat dissipation portion 170 is provided to cover the entire bottom surface 154b of the housing plate 154, for example.

The heat dissipation portion 170 is, for example, a heat dissipation sheet (a heat conduction sheet) attached to the bottom surface 154b of the housing plate 154, a TIM material applied to the bottom surface 154b of the housing plate 154, or the like.

In the present embodiment, the heat dissipation portion 170 is provided below the housing plate 154 to entirely contact the top surface 6a of the heat dissipation lid 6. That is, the heat dissipation portion 170 is provided to fill a gap between the housing plate 154 and the heat dissipation lid 6 therewith. However, the heat dissipation portion 170 may be provided as a portion not contacting the top surface 6a of the heat dissipation lid 6. In addition, the heat dissipation portion 170 may be provided to contact the inner wall surface 161b of the sidewall portion 161B of the housing 152, as in the illustrated example. In addition, the heat dissipation portion 170 may be provided on a side of the top surface 154a of the housing plate 154.

According to the configuration of this modification example, the heat dissipation portion 170 is provided on the housing plate 154, which makes it easy to dissipate heat generated in the solid-state imaging device 100 to the housing 152 through the heat dissipation portion 170 and the housing plate 154. This makes it possible to improve the heat dissipation characteristics. In particular, according to a configuration in which the heat dissipation portion 170 is contacted with the heat dissipation lid 6, it is possible to efficiently dissipate heat generated in the LSI 5 to the housing 152, which makes it possible to effectively improve the heat dissipation characteristics.

In addition, according to the configuration of this modification example, it is possible to improve the heat dissipation property by contriving the shapes and structures of the housing 152 and the housing plate 154 integrated with the housing 152. As a result, it is possible to obtain a relatively high degree of freedom in contrivances of the configuration for improving the heat dissipation property, as compared with, for example, a case where the heat dissipation property is improved only by contrivances of the configuration of the solid-state imaging device 100.

In addition, in this modification example, the housing plate 154 is provided as a portion integral with the housing 152. As a result, as compared with a configuration in which the housing plate 154 is provided as an attachment member to the housing 152, it is possible to reduce the number of components, and it is not necessary to attach the housing plate 154 to the housing 152, which makes it possible to achieve favorable assemblability for the imaging device 150.

### <21. Configuration Example of Electronic Apparatus>

Description is given, with reference to FIG. 35, of an application example of a semiconductor device according to any of the embodiments described above to an electronic apparatus.

The semiconductor device (the solid-state imaging device) according to the present technology is applicable, for example, as any of various devices that sense light such as visible light, infrared light, ultraviolet light, and X-rays. The solid-state imaging device according to the present technology is applicable to electronic apparatuses in general using a solid-state imaging element as an image capturing section (a photoelectric conversion section) including a camera device such as a digital still camera or a video camera, mobile terminal device having an imaging function, a copying machine using a solid-state imaging element as an image reading section, an in-vehicle sensor that captures an image of a front side, a rear side, surroundings, an inside, or the like of an automobile, and a distance measurement sensor that measures, for example, a distance between vehicles. In addition, the solid-state imaging device may be in a form formed as a one chip, or may be in a modular form having an imaging function in which an imaging section and a signal processor or an optical system are packaged together.

As illustrated in FIG. 35, a camera device 200 as an electronic apparatus includes an optical section 202, a solid-state imaging device 201, a DSP (Digital Signal Processor) circuit 203 that is a camera signal processing circuit, a frame memory 204, a display section 205, a recording section 206, an operation section 207, and a power supply section 208. The DSP circuit 203, the frame memory 204, the display section 205, the recording section 206, the operation section 207, and the power supply section 208 are coupled to each other through a coupling line 209 such as a bus line. The solid-state imaging device 201 corresponds to any one of the solid-state imaging devices according to the respective embodiments described above.

The optical section 202 includes a plurality of lenses, and takes in incident light (image light) from a subject to form an image on an imaging plane of the solid-state imaging device 201. The solid-state imaging device 201 converts a light amount of the incident light of which the image is formed on the imaging plane by the optical section 202 into electric signals on a pixel-by-pixel basis, and outputs the electric signals as pixel signals.

The display section 205 includes, for example, a panel-type display device such as a liquid crystal panel or an organic EL (Electro Luminescence) panel, and displays a moving image or a still image captured by the solid-state imaging device 201. The recording section 206 records the moving image or the still image captured by the solid-state imaging device 201 on a recording medium such as a hard disk or a semiconductor memory.

The operation section 207 issues an operation command for various functions of the camera device 200 in accordance with an operation by a user. The power supply section 208 supplies the DSP circuit 203, the frame memory 204, the display section 205, the recording section 206, and the operation section 207 with various types of power as power for operating these supply targets as appropriate.

According to the camera device 200 as described above, it is possible to downsize a device configuration of the solid-state imaging device 201, and it is possible to suppress occurrence of a defect such as flare caused by the reflected light from the heat dissipation lid 6. In addition, achieving favorable heat dissipation characteristics in the solid-state imaging device 201 is beneficial in terms of maintaining a favorable operation state of the camera device 200 and achieving desired characteristics.

The description of each of the embodiments described above is an example of the present technology, and the present technology is not limited to the embodiments described above. Thus, it is needless to say that various modifications can be made according to design and the like without departing from the technical concept according to the present disclosure even in other embodiments than those described above. In addition, the effects described in the present disclosure are merely examples and are not limited, and other effects may be achieved. In addition, it is possible to combine the configuration of any of the embodiments described above and the configuration of any of the modification examples as appropriate.

In the embodiments described above, the first semiconductor element is the image sensor 3 that is a light-receiving element, but the first semiconductor element according to the present technology is not limited thereto. The first semiconductor element according to the present technology may be, for example, a light-emitting element such as a VCSEL (Vertical Cavity Surface Emitting LASER: vertical-cavity surface-emitting laser), a laser diode, or an LED (Light Emitting Diode).

In the embodiments described above, the second semiconductor element is the LSI 5, but the second semiconductor element according to the present technology is not limited thereto. The second semiconductor element according to the present technology may has, for example, a BGA (Ball Grid Array) package structure mounted on a substrate on which a plurality of solder balls is arranged as external coupling terminals in a lattice point pattern on a back surface side. In this case, the second semiconductor element is mounted on the substrate 2 by the plurality of solder balls forming a BGA.

In addition, in the embodiments described above, one LSI 5 mounted on the substrate 2 is provided as the second semiconductor element; however, a configuration including a plurality of second semiconductor elements may be adopted. That is, the semiconductor device according to the present technology includes one or a plurality of second semiconductor elements.

It is to be noted that the present technology may have the following configurations.
(1) A semiconductor device including:
   a substrate;
   a first semiconductor element provided on the substrate;
   a light-transmissive member provided on the first semiconductor element on a side opposite to a side of the substrate;
   a second semiconductor element provided on the substrate; and
   a heat dissipation member provided on the second semiconductor element on the side opposite to the side of the substrate, in which
   the heat dissipation member is provided at a position lower than a top surface of the light-transmissive member.
(2) A semiconductor device including:
   a substrate;
   a first semiconductor element provided on the substrate;
   a light-transmissive member provided on the first semiconductor element on a side opposite to a side of the substrate;
   a second semiconductor element provided on the substrate; and
   a heat dissipation member provided on the second semiconductor element on the side opposite to the side of the substrate, in which
   the heat dissipation member has an opposed side surface opposed to the light-transmissive member, and
   the opposed side surface is formed at a position lower than a top surface of the light-transmissive member.
(3) The semiconductor device according to (1) or (2), including a support frame portion that is provided on the substrate, and supports the light-transmissive member and the heat dissipation member relative to the substrate.
(4) The semiconductor device according to any one of (1) to (3), in which the heat dissipation member includes a heat dissipation member main body portion that is positioned on the second semiconductor element, and a heat dissipation member extending portion that extends from the heat dissipation member main body portion to a region where the first semiconductor element is disposed in plan view.
(5) The semiconductor device according to (4), in which the heat dissipation member extending portion is provided to surround the first semiconductor element in plan view.
(6) The semiconductor device according to (1), in which the heat dissipation member includes a heat dissipation member main body portion that is positioned on the second semiconductor element, and a light-transmissive member support portion that extends from the heat dissipation member main body portion to a region where the first semiconductor element is disposed in plan view to support the light-transmissive member.
(7) A semiconductor device including:
   a substrate;
   a first semiconductor element provided on the substrate;
   a light-transmissive member provided on the first semiconductor element on a side opposite to a side of the substrate;
   a second semiconductor element provided on the substrate;
   a heat dissipation member provided on the second semiconductor element on the side opposite to the side of the substrate; and
   a light-blocking portion interposed between the light-transmissive member and the heat dissipation member.
(8) The semiconductor device according to (7), including a support frame portion that is provided on the substrate, and supports the light-transmissive member and the heat dissipation member relative to the substrate, in which
   the light-blocking portion is provided as a portion of the support frame portion.
(9) The semiconductor device according to (7), in which the light-blocking portion is formed by a resin filled between the light-transmissive member and the heat dissipation member.
(10) The semiconductor device according to (9), in which the heat dissipation member has a recessed portion that takes in a resin material that is to form the light-blocking portion.
(11) The semiconductor device according to (7), in which the light-blocking portion includes a covering portion that covers at least a side surface of the light-transmissive member on a side of the heat dissipation member.
(12) The semiconductor device according to any one of (1) to (11), in which at least a portion of a surface of the heat dissipation member serves as a low reflection portion that is less reflective to light than another portion of the heat dissipation member.
(13) The semiconductor device according to any one of (1) to (12), including a heat dissipator having a sheet shape that is provided on a top surface of the heat dissipation member.
(14) The semiconductor device according to any one of (1) to (13), in which the heat dissipation member includes a heat dissipation member main body portion that is positioned on the second semiconductor element, and a plurality of protrusion portions that each protrudes from the heat dissipation member main body portion.
(15) The semiconductor device according to any one of (1) to (14), including:
   a mounting substrate on which the substrate is mounted;
   a housing that holds a lens provided for the first imaging element; and
   a light-blocking member that is provided in the housing, and covers at least a portion of the heat dissipation member from the side opposite to the side of the substrate.
(16) The semiconductor device according to (15), in which a heat dissipation portion having a thermal conductivity higher than a thermal conductivity of a material included in the light-blocking member is provided on the light-blocking member.
(17) An electronic apparatus provided with a semiconductor device, the semiconductor device including:
   a substrate;
   a first semiconductor element provided on the substrate;
   a light-transmissive member provided on the first semiconductor element on a side opposite to a side of the substrate;
   a second semiconductor element provided on the substrate; and
   a heat dissipation member provided on the second semiconductor element on the side opposite to the side of the substrate, in which
   the heat dissipation member is provided at a position lower than a top surface of the light-transmissive member.
(18) An electronic apparatus provided with a semiconductor device, the semiconductor device including:
   a substrate;
   a first semiconductor element provided on the substrate;
   a light-transmissive member provided on the first semiconductor element on a side opposite to a side of the substrate;
   a second semiconductor element provided on the substrate; and
   a heat dissipation member provided on the second semiconductor element on the side opposite to the side of the substrate, in which
   the heat dissipation member has an opposed side surface opposed to the light-transmissive member, and
   the opposed side surface is formed at a position lower than a top surface of the light-transmissive member.
(19) An electronic apparatus provided with a semiconductor device, the semiconductor device including:
   a substrate;
   a first semiconductor element provided on the substrate;
   a light-transmissive member provided on the first semiconductor element on a side opposite to a side of the substrate;
   a second semiconductor element provided on the substrate;
   a heat dissipation member provided on the second semiconductor element on the side opposite to the side of the substrate; and
   a light-blocking portion interposed between the light-transmissive member and the heat dissipation member.

### [Reference Numerals List]

- 1: solid-state imaging device (semiconductor device)
- 2: substrate
- 3: image sensor (first semiconductor element)
- 4: glass (light-transmissive member )
- 4a: top surface
- 5: LSI (second semiconductor element)
- 6: heat dissipation lid (heat dissipation member)
- 7: stiffener (support frame portion)
- 44: low reflection portion
- 45: heat dissipation sheet (heat dissipator)
- 46: heat dissipation member main body portion
- 47: fin (protrusion portion)
- 51: heat dissipation member main body portion
- 52: heat dissipation member extending portion
- 72: opposed side surface
- 81: heat dissipation member main body portion
- 82: light-transmissive member support portion
- 100: solid-state imaging device (semiconductor device)
- 101: light-blocking wall (light-blocking portion)
- 111: resin-applied portion (light-blocking portion )
- 115: recessed portion
- 121: covering resin portion (light-blocking portion)
- 131: light-blocking film (light-blocking portion)
- 150: imaging device (semiconductor device)
- 151: set substrate (mounting substrate)
- 152: housing
- 153: lens
- 154: housing plate (light-blocking member)
- 170: heat dissipation portion
- 200: camera device (electronic apparatus)
- 201: solid-state imaging device (semiconductor device)

## Claims

1. A semiconductor device comprising:
a substrate;
a first semiconductor element provided on the substrate;
a light-transmissive member provided on the first semiconductor element on a side opposite to a side of the substrate;
a second semiconductor element provided on the substrate; and
a heat dissipation member provided on the second semiconductor element on the side opposite to the side of the substrate, wherein
the heat dissipation member is provided at a position lower than a top surface of the light-transmissive member.

2. A semiconductor device comprising:
a substrate;
a first semiconductor element provided on the substrate;
a light-transmissive member provided on the first semiconductor element on a side opposite to a side of the substrate;
a second semiconductor element provided on the substrate; and
a heat dissipation member provided on the second semiconductor element on the side opposite to the side of the substrate, wherein
the heat dissipation member has an opposed side surface opposed to the light-transmissive member, and
the opposed side surface is formed at a position lower than a top surface of the light-transmissive member.

3. The semiconductor device according to claim 1, comprising a support frame portion that is provided on the substrate, and supports the light-transmissive member and the heat dissipation member relative to the substrate.

4. The semiconductor device according to claim 1, wherein the heat dissipation member includes a heat dissipation member main body portion that is positioned on the second semiconductor element, and a heat dissipation member extending portion that extends from the heat dissipation member main body portion to a region where the first semiconductor element is disposed in plan view.

5. The semiconductor device according to claim 4, wherein the heat dissipation member extending portion is provided to surround the first semiconductor element in plan view.

6. The semiconductor device according to claim 1, wherein the heat dissipation member includes a heat dissipation member main body portion that is positioned on the second semiconductor element, and a light-transmissive member support portion that extends from the heat dissipation member main body portion to a region where the first semiconductor element is disposed in plan view to support the light-transmissive member.

7. A semiconductor device comprising:
a substrate;
a first semiconductor element provided on the substrate;
a light-transmissive member provided on the first semiconductor element on a side opposite to a side of the substrate;
a second semiconductor element provided on the substrate;
a heat dissipation member provided on the second semiconductor element on the side opposite to the side of the substrate; and
a light-blocking portion interposed between the light-transmissive member and the heat dissipation member.

8. The semiconductor device according to claim 7, comprising a support frame portion that is provided on the substrate, and supports the light-transmissive member and the heat dissipation member relative to the substrate, wherein
the light-blocking portion is provided as a portion of the support frame portion.

9. The semiconductor device according to claim 7, wherein the light-blocking portion is formed by a resin filled between the light-transmissive member and the heat dissipation member.

10. The semiconductor device according to claim 9, wherein the heat dissipation member has a recessed portion that takes in a resin material that is to form the light-blocking portion.

11. The semiconductor device according to claim 7, wherein the light-blocking portion comprises a covering portion that covers at least a side surface of the light-transmissive member on a side of the heat dissipation member.

12. The semiconductor device according to claim 1, wherein at least a portion of a surface of the heat dissipation member serves as a low reflection portion that is less reflective to light than another portion of the heat dissipation member.

13. The semiconductor device according to claim 1, comprising a heat dissipator having a sheet shape that is provided on a top surface of the heat dissipation member.

14. The semiconductor device according to claim 1, wherein the heat dissipation member includes a heat dissipation member main body portion that is positioned on the second semiconductor element, and a plurality of protrusion portions that each protrudes from the heat dissipation member main body portion.

15. The semiconductor device according to claim 1, comprising:
a mounting substrate on which the substrate is mounted;
a housing that holds a lens provided for the first imaging element; and
a light-blocking member that is provided in the housing, and covers at least a portion of the heat dissipation member from the side opposite to the side of the substrate.

16. The semiconductor device according to claim 15, wherein a heat dissipation portion having a thermal conductivity higher than a thermal conductivity of a material included in the light-blocking member is provided on the light-blocking member.

17. An electronic apparatus provided with a semiconductor device, the semiconductor device comprising:
a substrate;
a first semiconductor element provided on the substrate;
a light-transmissive member provided on the first semiconductor element on a side opposite to a side of the substrate;
a second semiconductor element provided on the substrate; and
a heat dissipation member provided on the second semiconductor element on the side opposite to the side of the substrate, wherein
the heat dissipation member is provided at a position lower than a top surface of the light-transmissive member.

18. An electronic apparatus provided with a semiconductor device, the semiconductor device comprising:
a substrate;
a first semiconductor element provided on the substrate;
a light-transmissive member provided on the first semiconductor element on a side opposite to a side of the substrate;
a second semiconductor element provided on the substrate; and
a heat dissipation member provided on the second semiconductor element on the side opposite to the side of the substrate, wherein
the heat dissipation member has an opposed side surface opposed to the light-transmissive member, and
the opposed side surface is formed at a position lower than a top surface of the light-transmissive member.

19. An electronic apparatus provided with a semiconductor device, the semiconductor device comprising:
a substrate;
a first semiconductor element provided on the substrate;
a light-transmissive member provided on the first semiconductor element on a side opposite to a side of the substrate;
a second semiconductor element provided on the substrate;
a heat dissipation member provided on the second semiconductor element on the side opposite to the side of the substrate; and
a light-blocking portion interposed between the light-transmissive member and the heat dissipation member.
